# EUROPEAN PATENT APPLICATION

(11) **EP 4 845 329 A1**
(43) Date of publication of application: **25.11.2026**
(21) Application number: 25227125.9
(22) Date of filing: 23.12.2025
(51) Int. Cl.: H10B 12/00

(54) **SEMICONDUCTOR DEVICE**

(30) Priority: 22.05.2025 KR 20250067000
(71) Applicant: Samsung Electronics Co., Ltd., Suwon-si, Gyeonggi-do 16677 (KR)
(72) Inventor: PARK, Taejin, Suwon-si (KR); KIM, Eunjung, Suwon-si (KR); YIM, Sung Soo, Suwon-si (KR)
(74) Representative: Marks & Clerk LLP

(57) **Abstract**

This disclosure relates to a semiconductor device, and a semiconductor device according to embodiments comprises a bit line extending in a first direction, a word line on a lower surface of the bit line and extending in a second direction intersecting the first direction, an active pattern extending from the lower surface of the bit line in a third direction intersecting the first direction and the second direction and overlapping the word line in the first direction, a capacitor on a lower surface of the active pattern, a cell wiring layer on an upper surface of the bit line, a bit line contact connecting the cell wiring layer and the bit line, and a bit line insulating pattern between two bit lines adjacent in the first direction among a plurality of bit lines including the bit line, wherein the bit line insulating pattern overlaps, in the second direction, another bit line different from the two bit lines.

## Description

### FIELD

This disclosure relates to a semiconductor device.

### BACKGROUND

A technology for increasing the integration degree of semiconductor memory devices is required. In the case of a two-dimensional or planar semiconductor memory device, integration density is determined by the area occupied by a unit memory cell, and as a result, the level of fine pattern formation technology may have a significant impact on the integration density.

However, fine patterning requires expensive equipment and highly advanced process technology, and therefore, there is a limitation in improving the integration density of two-dimensional semiconductor memory devices.

### SUMMARY

The embodiments are to provide a semiconductor device that may improve data transmission reliability. In addition, embodiments are for providing a semiconductor device that may improve integration density.

A semiconductor device according to embodiments comprises a bit line extending in a first direction, a word line on a lower surface of the bit line and extending in a second direction intersecting the first direction, an active pattern extending from the lower surface of the bit line in a third direction intersecting the first direction and the second direction and overlapping the word line in the first direction, a capacitor on a lower surface of the active pattern, a cell wiring layer on an upper surface of the bit line, a bit line contact connecting the cell wiring layer and the bit line, and a bit line insulating pattern between two bit lines adjacent in the first direction among a plurality of bit lines including the bit line, wherein the bit line insulating pattern overlaps, in the second direction, another bit line different from the two bit lines.

A semiconductor device according to embodiments comprises a plurality of bit lines extending in a first direction, a plurality of word lines on lower surfaces of the plurality of bit lines and extending in a second direction intersecting the first direction, a plurality of active patterns extending from the lower surfaces of the plurality of bit lines in a third direction intersecting the first direction and the second direction, and overlapping the plurality of word lines in the first direction, a plurality of capacitors on lower surfaces of the plurality of active patterns, a cell wiring layer on upper surfaces of the plurality of bit lines, a plurality of bit line contacts connecting the cell wiring layer and the plurality of bit lines, and a plurality of bit line insulating patterns respectively between the plurality of bit lines spaced apart in the first direction, wherein the plurality of bit lines includes a plurality of first bit lines and a plurality of second bit lines adjacent in the second direction, wherein each of the plurality of first bit lines and the plurality of second bit lines are arranged spaced apart in the first direction, and wherein the plurality of first bit lines and the plurality of second bit lines are arranged in a staggered manner in the second direction.

A semiconductor device according to embodiments comprises a plurality of bit lines extending in a first direction, a plurality of word lines on lower surfaces of the plurality of bit lines and extending in a second direction intersecting the first direction, a plurality of active patterns extending from the lower surfaces of the plurality of bit lines in a third direction intersecting the first direction and the second direction, and overlapping the plurality of word lines in the first direction, a plurality of capacitors on the lower surfaces of the plurality of active patterns, a cell wiring layer on upper surfaces of the plurality of bit lines, a plurality of bit line contacts connecting the cell wiring layer and the plurality of bit lines, and a plurality of bit line insulating patterns respectively between the plurality of bit lines spaced apart in the first direction, wherein the plurality of bit lines include a plurality of first bit lines and a plurality of second bit lines adjacent in the second direction, and each of the plurality of first bit lines and the plurality of second bit lines is arranged spaced apart in the first direction, wherein the plurality of bit line insulating patterns include a plurality of first bit line insulating patterns alternately and repeatedly arranged with the plurality of first bit lines along the first direction, and a plurality of second bit line insulating patterns alternately and repeatedly arranged with the plurality of second bit lines along the first direction, wherein the plurality of first bit lines overlap the plurality of second bit line insulating patterns in the second direction, wherein the plurality of second bit lines overlap the plurality of first bit line insulating patterns in the second direction, and wherein the plurality of bit line contacts overlap the plurality of capacitors in the third direction.

According to embodiments, it may be possible to improve the data transmission reliability of a semiconductor device. In addition, according to embodiments, the integration degree of the semiconductor device may be improved.

At least some of the above and other features of the invention are set out in the claims.

### BRIEF DESCRIPTION OF THE DRAWINGS

FIG. 1 is a cross-sectional view of a semiconductor device according to embodiments.
FIG. 2 is a plan layout view illustrating a part of the configuration of a semiconductor device according to embodiments.
FIG. 3 is a plan view showing a part of a semiconductor device according to embodiments.
FIG. 4 shows cross-sectional views taken along line A-A' and line B-B' of FIG. 3.
FIG. 5 is a plan view showing a part of the configuration of a semiconductor device according to a comparative example.
FIG. 6 shows cross-sectional views taken along the A-A' line and B-B' line of FIG. 3.
FIG. 7 is a plan view showing a part of a semiconductor device according to embodiments.
FIGS. 8 to 20 are process cross-sectional views illustrating a method of manufacturing a semiconductor device according to embodiments.

### DETAILED DESCRIPTION

Hereinafter, various embodiments of the present invention will be described in detail with reference to the accompanying drawings so that those skilled in the art to which the present invention pertains may easily carry out the invention. The present invention may be implemented in various different forms and is not limited to the embodiments described herein.

In order to clearly describe the present invention, portions unrelated to the description are omitted, and throughout the specification, identical or similar components are designated with the same reference numerals.

In addition, the size and thickness of each component shown in the drawings are illustrated arbitrarily for convenience of explanation, so the present invention is not necessarily limited to what is depicted. In the drawings, the thickness is illustrated in an enlarged manner in order to clearly represent the various layers and regions. In the drawings, for convenience of explanation, the thicknesses of some layers and regions are illustrated in an exaggerated manner.

In addition, when it is stated that a portion such as a layer, film, region, or plate is on or above another portion, this includes not only cases where it is immediately on the other portion but also cases where another portion is interposed therebetween. Conversely, when a certain portion is said to be "directly on" another portion, it means that there is no other portion in between. In addition, the expression that a portion is "on" or "above" a reference portion means that it is positioned above or below the reference portion, and does not necessarily mean that it is positioned "on" or "above" the side opposite to the direction of gravity.

In addition, throughout the specification, when a part is described as "including" a certain component, this means that, unless specifically stated otherwise, it does not exclude other components but may further include other components.

In addition, throughout the specification, when referred to as "in plan view," this means as seen from above the subject part, and when referred to as "in cross-sectional view," this means as seen from the side of a cross-section cut vertically through the subject part.

Semiconductor memory devices including a vertical channel transistor having a channel extending in a direction perpendicular to a substrate are being proposed. The vertical channel transistor structure may maximize the integration density of the two-dimensional semiconductor memory device by increasing the number of cells per unit area.

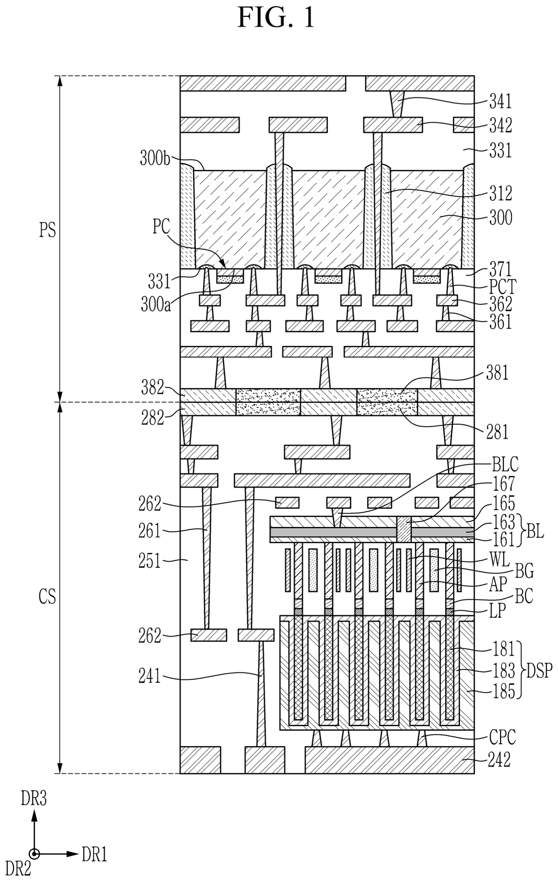

Hereinafter, a semiconductor device according to embodiments will be described with reference to FIGS. 1 to 4.

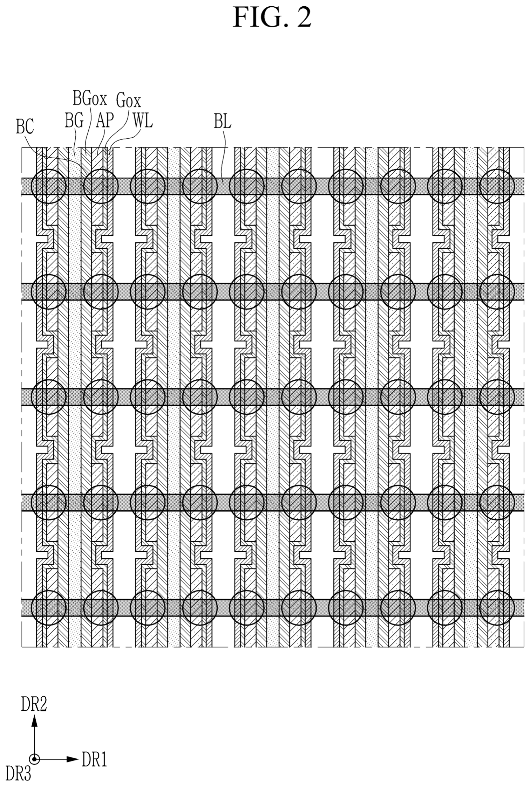

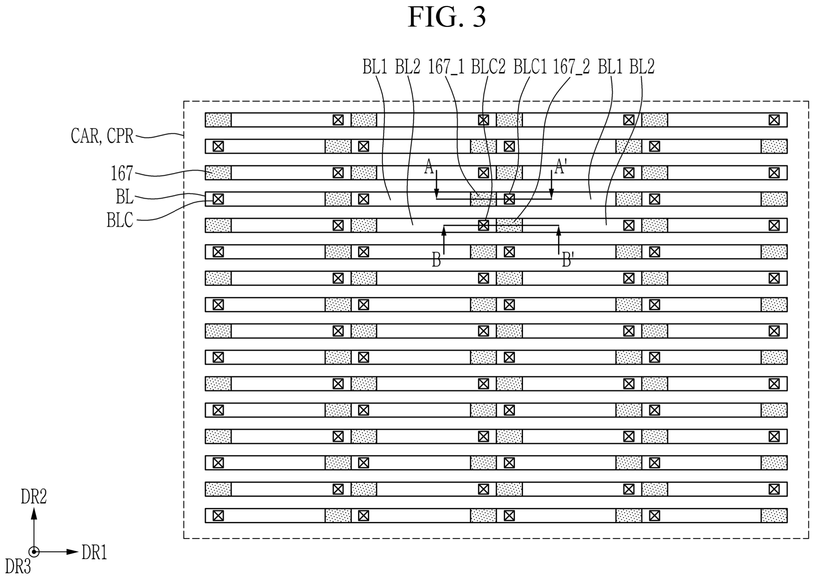

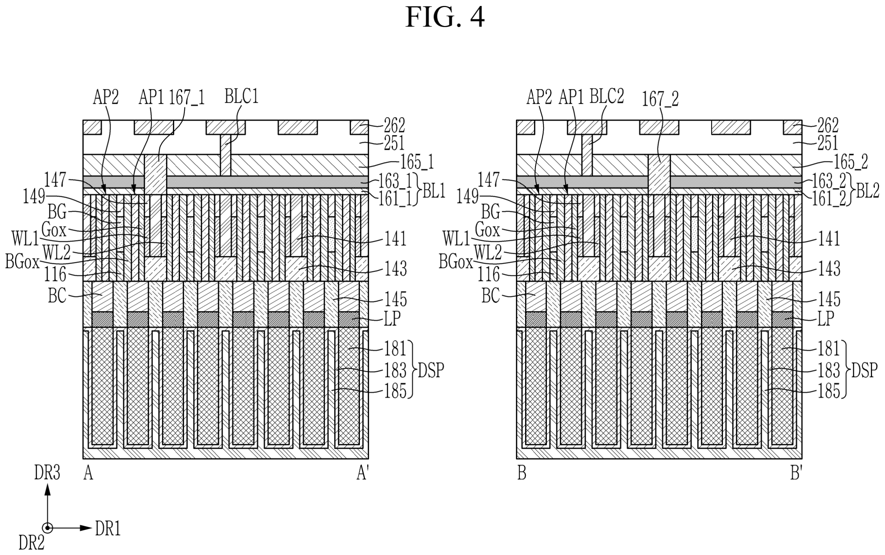

FIG. 1 is a cross-sectional view of a semiconductor device according to embodiments. FIG. 2 is a plan layout view illustrating a part of a configuration of a semiconductor device according to embodiments. FIG. 3 is a plan view showing a part of a semiconductor device according to embodiments. FIG. 1 is a diagram illustrating a structure in which the cell structure CS and the peripheral circuit structure PS of a semiconductor device according to embodiments are stacked. FIG. 2 is a plan layout view showing a part of the configuration of the cell structure CS of a semiconductor device according to embodiments, and for convenience, only the active pattern AP, bit line BL, word line WL, gate insulating pattern Gox, back gate electrode BG, back gate insulating pattern BGox, and storage contact BC are illustrated, and illustration of other components is omitted. FIG. 3 is a drawing illustrating a configuration in which a plurality of bit lines are arranged in a semiconductor device according to embodiments, and, for convenience, only the bit line BL, bit line contact BLC, and bit line insulating pattern 167 are illustrated, with illustration of other components being omitted. FIG. 4 shows cross-sectional views taken along the A-A' line and B-B' line of FIG. 3. The A-A' cross-section and B-B' cross-section of FIG. 4 may be cross-sections overlapping in the second direction DR2.

Referring to FIG. 1, a semiconductor device according to embodiments may include a cell structure CS and a peripheral circuit structure PS. The peripheral circuit structure PS may include the substrate 300. As shown in FIG. 1, the cell structure CS may not include a substrate. For example, in a manufacturing process of a semiconductor device, a cell structure CS may be formed on a substrate, but after forming an active pattern AP as a part of the substrate and removing the remaining portion of the substrate, the cell structure CS in the final structure may not include the substrate.

The substrate 300 may be a semiconductor substrate. For example, the substrate 300 may be a silicon substrate or a silicon germanium substrate. Alternatively, the substrate 300 may be a Group III-V compound semiconductor, a Group II-VI compound semiconductor, or a Group IV-IV compound semiconductor substrate. For example, the substrate 300 may include materials such as indium antimonide, lead telluride, indium arsenide, indium phosphide, gallium arsenide, or gallium antimonide. However, it is not limited thereto, and the material including the substrate 300 may be variously changed.

The substrate 300 may include a first surface 300a and a second surface 300b facing each other. In FIG. 1, the first surface 300a of the substrate 300 may be a lower surface of the substrate 300, and the second surface 300b of the substrate 300 may be an upper surface of the substrate 300. However, according to embodiments, the first surface 300a of the substrate 300 may be an upper surface of the substrate 300, and the second surface 300b of the substrate 300 may also be a lower surface of the substrate 300.

A cell structure CS may be positioned on the first surface 300a of the substrate 300. A portion of the peripheral circuit structure PS is positioned on the first surface 300a of the substrate 300, and another portion of the peripheral circuit structure PS may be positioned on the second surface 300b of the substrate 300. The cell structure CS and peripheral circuit structure PS may be stacked in a direction perpendicular to the first surface 300a of the substrate 300 for example, a third direction DR3. In FIG. 1, the peripheral circuit structure PS is illustrated as being stacked on the cell structure CS. However, the present invention is not limited thereto, and the cell structure CS may also be stacked on the peripheral circuit structure PS.

The cell structure CS may include a plurality of memory cells. Each of the plurality of memory cells may include a bit line BL, a word line WL, an active pattern AP, and a capacitor DSP. The bit line BL, word line WL, active pattern AP, and capacitor DSP will be described in greater detail below. Each of the plurality of memory cells may include one transistor and one capacitor. For example, the memory cell may be a DRAM cell. For example, the transistor of the memory cell may be a vertical channel transistor (VCT).

The cell structure CS may include a first cell wiring layer 262, a first cell wiring via 261, a second cell wiring layer 242, a second cell wiring via 241, and a cell insulating layer 251. The first cell wiring layer 262 is a wiring layer positioned on the plurality of memory cells, and the second cell wiring layer 242 may be a wiring layer positioned below the plurality of memory cells. The first cell wiring layer 262 may be positioned on the bit line BL. The second cell wiring layer 242 may be positioned on the capacitor DSP. The first cell wiring layer 262 may include a plurality of wiring layers spaced apart in the third direction DR3. The third direction DR3 may be a direction perpendicular to the first surface 300a of the substrate 300. In FIG. 1, the second cell wiring layer 242 is illustrated as being formed of a single wiring layer; however, it is not limited thereto, and the second cell wiring layer 242 may include a plurality of wiring layers spaced apart in the third direction DR3.

The first cell wiring via 261 may connect between a plurality of wiring layers spaced apart in the third direction DR3 of the first cell wiring layer 262. The first cell wiring via 261 may connect between an uppermost wiring layer among the plurality of wiring layers of the first cell wiring layer 262 and a first connection pad 282 to be described later. The first cell wiring via 261 may include a bit line contact BLC connecting the first cell wiring layer 262 and the bit line BL. The bit line contact BLC will be described in more detail below.

The second cell wiring via 241 may connect between the second cell wiring layer 242 and the first cell wiring layer 262. However, the embodiments are not limited thereto, and the second cell wiring layer 242 and the first cell wiring layer 262 may be connected by the first cell wiring via 261. In the case where the second cell wiring layer 242 includes a plurality of wiring layers spaced apart in the third direction DR3, the second cell wiring via 241 may connect between the plurality of wiring layers spaced apart in the third direction DR3 of the second cell wiring layer 242. The second cell wiring via 241 may include a capacitor contact CPC connecting the second cell wiring layer 242 and the capacitor DSP. The capacitor contact CPC may be connected to a second electrode 185 of the capacitor DSP.

The first cell wiring layer 262, the first cell wiring via 261, the second cell wiring layer 242, and the second cell wiring via 241 may include a conductive material. The first cell wiring layer 262, the first cell wiring via 261, the second cell wiring layer 242, and the second cell wiring via 241 may include a metal. For example, the first cell wiring layer 262, the first cell wiring via 261, the second cell wiring layer 242, and the second cell wiring via 241 may each include aluminum (Al), tungsten (W), titanium (Ti), copper (Cu), or tantalum (Ta), but are not limited thereto.

The cell insulating layer 251 may surround the first cell wiring layer 262 and the first cell wiring via 261. The cell insulating layer 251 may be positioned between a plurality of wiring layers spaced apart in the third direction DR3 from the first cell wiring layer 262. The cell insulating layer 251 may be positioned on the upper surface and the lower surface of each of the plurality of wiring layers of the first cell wiring layer 262. Each wiring layer of the first cell wiring layer 262 may include a plurality of wires spaced apart in the first direction DR1 or the second direction DR2. The cell insulating layer 251 may be positioned between a plurality of wirings spaced apart in the first direction DR1 or the second direction DR2. The cell insulating layer 251 may be positioned on side surfaces of a plurality of wirings spaced apart in the first direction DR1 or the second direction DR2. The first cell wiring via 261 may connect between wiring layers among the plurality of wiring layers of the first cell wiring layer 262, between the uppermost wiring layer of the first cell wiring layer 262 and the first connection pad 282, and between the first cell wiring layer 262 and the bit line BL, through the cell insulating layer 251. The cell insulating layer 251 may be positioned on the side surface of the first cell wiring via 261.

The cell insulating layer 251 may surround the second cell wiring layer 242 and the second cell wiring via 241. The cell insulating layer 251 may be positioned between the first cell wiring layer 262 and the second cell wiring layer 242. The cell insulating layer 251 may be positioned on the lower surface of the first cell wiring layer 262 and on the upper surface of the second cell wiring layer 242. The second cell wiring layer 242 may include a plurality of wirings spaced apart in the first direction DR1 or the second direction DR2. The cell insulating layer 251 may be positioned on side surfaces of a plurality of wirings spaced apart in the first direction DR1 or the second direction DR2. When the second cell wiring layer 242 includes a plurality of wiring layers spaced apart in the third direction DR3, the cell insulating layer 251 may be positioned between the plurality of wiring layers spaced apart in the third direction DR3. In this case, the cell insulating layer 251 may be positioned on the upper surface and lower surface of each of the plurality of wiring layers of the first cell wiring layer 262. The second cell wiring via 241 may connect between the second cell wiring layer 242 and the first cell wiring layer 262, and between the second cell wiring layer 242 and the capacitor DSP, through the cell insulating layer 251. In some cases, the second cell wiring via 241 may penetrate the cell insulating layer 251 to connect between the plurality of wiring layers of the second cell wiring layer 242. The cell insulating layer 251 may be positioned on the side surface of the second cell wiring via 241.

The cell insulating layer 251 may include an insulating material. For example, the cell insulating layer 251 may include silicon oxide, but is not limited thereto.

The cell structure CS may include a first connection pad 282 and a first pad insulating layer 281. The first connection pad 282 and the first pad insulating layer 281 may be positioned on the first cell wiring layer 262, the first cell wiring via 261, and the cell insulating layer 251, but are not limited thereto. Unlike embodiments shown in FIG. 1, the cell structure CS may be stacked in the third direction DR3 on the peripheral circuit structure PS. In this case, the first connection pad 282 and the first pad insulating layer 281 may be positioned on the second cell wiring layer 242, the second cell wiring via 241, and the cell insulating layer 251.

The cell structure CS may include a plurality of first connection pads 282. The plurality of first connection pads 282 may be arranged spaced apart in a direction parallel to the first surface 300a of the substrate 300 for example, the first direction DR1. A first pad insulating layer 281 may be positioned between the plurality of first connection pads 282. The first pad insulating layer 281 may surround the side surfaces of the plurality of first connection pads 282. The cell structure CS may be bonded to the peripheral circuit structure PS through the first connection pad 282 and the first pad insulating layer 281. The bonding between the cell structure CS and the peripheral circuit structure PS will be described in more detail below.

The peripheral circuit structure PS may include a peripheral circuit PC positioned on the first surface 300a of the substrate 300. The peripheral circuit PC may include a circuit for driving the memory cell. The peripheral circuit PC may include a core circuit and a peri circuit. The core circuit may include a word line driver, a sense amplifier, a row decoder, a column decoder, a read/write circuit, or a combination thereof. The peri circuit may include a timing register, an address register, a data input register, a data output register, a data input/output terminal, or a combination thereof. For example, the peripheral circuit PC may include a sensing transistor, a transfer transistor, a driving transistor, or a combination thereof.

In the substrate 300, a device isolation insulating layer 312 may be positioned, and by the device isolation insulating layer 312, elements included in the peripheral circuit PC may be electrically isolated. The device isolation insulating layer 312 may penetrate the substrate 300 in the third direction DR3, but is not limited thereto. For example, the device isolation insulating layer 312 may be embedded in the first surface 300a of the substrate 300, and in this case, the height of the device isolation insulating layer 312 in the third direction DR3 may be less than the height of the substrate 300 in the third direction DR3.

The peripheral circuit structure PS may include a first circuit wiring layer 362, a first circuit wiring via 361, and a first circuit insulating layer 371 positioned on the first surface 300a of the substrate 300. The peripheral circuit structure PS may include a second circuit wiring layer 342, a second circuit wiring via 341, and a second circuit insulating layer 331 positioned on the second surface 300b of the substrate 300.

The first circuit wiring layer 362 may be positioned on the peripheral circuit PC. The first circuit wiring layer 362 may include a plurality of wiring layers spaced apart in the third direction DR3. The first circuit wiring via 361 may connect between a plurality of wiring layers spaced apart in the third direction DR3 of the first circuit wiring layer 362. The first circuit wiring via 361 may connect between the uppermost wiring layer among the plurality of wiring layers of the first circuit wiring layer 362 and a second connection pad 382 to be described later. The first circuit wiring via 361 may include a peripheral circuit contact (PCT) connecting the first circuit wiring layer 362 and the source/drain region or gate electrode of a device included in the peripheral circuit PC.

The first circuit insulating layer 371 may surround the first circuit wiring layer 362 and the first circuit wiring via 361. The first circuit insulating layer 371 may be positioned between a plurality of wiring layers of the first circuit wiring layer 362, spaced apart in the third direction DR3. The first circuit insulating layer 371 may be positioned on the upper surface and the lower surface of each of the plurality of wiring layers of the first circuit wiring layer 362. Each of the plurality of wiring layers of the first circuit wiring layer 362 may include a plurality of wirings spaced apart in the first direction DR1 or the second direction DR2. The first circuit insulating layer 371 may be positioned between a plurality of wirings spaced apart in the first direction DR1 or the second direction DR2. The first circuit insulating layer 371 may be positioned on the side surfaces of a plurality of wirings spaced apart in the first direction DR1 or the second direction DR2. The first circuit wiring via 361 may connect between plurality of wiring layers of the first circuit insulating layer 371, between an uppermost wiring layer of the first circuit insulating layer 371 and the second connection pad 382, and between the first circuit insulating layer 371 and a source/drain region or a gate electrode of a device included in the peripheral circuit PC, through the first circuit insulating layer 371. The first circuit insulating layer 371 may be positioned on the side surface of the first circuit wiring via 361.

The first circuit wiring layer 362 and the first circuit wiring via 361 each may include a conductive material. The first circuit wiring layer 362 and the first circuit wiring via 361 each may include a metal. For example, the first circuit wiring layer 362 and the first circuit wiring via 361 each may include aluminum (Al), tungsten (W), titanium (Ti), copper (Cu), or tantalum (Ta), but are not limited thereto.

The first circuit insulating layer 371 may include an insulating material. For example, the first circuit insulating layer 371 may include silicon oxide, but is not limited thereto.

The second circuit wiring layer 342 may be positioned on the second surface 300b of the substrate 300. The second circuit wiring layer 342 may include a plurality of wiring layers spaced apart in the third direction DR3. The second circuit wiring via 341 may connect a plurality of wiring layers of the second circuit wiring layer 342, spaced apart in the third direction DR3. The second circuit wiring via 341 may connect between the second circuit wiring layer 342 and the first circuit wiring layer 362. However, embodiments are not limited thereto, and the second circuit wiring layer 342 and the first circuit wiring layer 362 may be connected by the first circuit wiring via 361.

The second circuit insulating layer 331 may surround the second circuit wiring layer 342 and the second circuit wiring via 341. The second circuit insulating layer 331 may be positioned between a plurality of wiring layers of the second circuit wiring layer 342 spaced apart in the third direction DR3. The second circuit insulating layer 331 may be positioned on the upper surface and the lower surface of each of the plurality of wiring layers of the second circuit wiring layer 342. Each of the plurality of wiring layers of the second circuit wiring layer 342 may include a plurality of wirings spaced apart in the first direction DR1 or the second direction DR2. The second circuit insulating layer 331 may be positioned between a plurality of wirings spaced apart in the first direction DR1 or the second direction DR2. The second circuit insulating layer 331 may be positioned on the side surfaces of a plurality of wirings spaced apart in the first direction DR1 or the second direction DR2. The second circuit wiring via 341 may connect between the plurality of wiring layers of the second circuit wiring layer 342, and between the second circuit wiring layer 342 and the first circuit wiring layer 362, through the second circuit insulating layer 331. The second circuit insulating layer 331 may be positioned on the side surface of the second circuit wiring via 341.

The second circuit wiring via 341 may penetrate the second circuit insulating layer 331, the device isolation insulating layer 312, and the first circuit insulating layer 371. The second circuit insulating layer 331, the device isolation insulating layer 312, and the first circuit insulating layer 371 may be positioned on the side surface of the second circuit wiring via 341.

The second circuit wiring layer 342 and the second circuit wiring via 341 each may include a conductive material. The second circuit wiring layer 342 and the second circuit wiring via 341 each may include a metal. For example, the second circuit wiring layer 342 and the second circuit wiring via 341 may each include aluminum (Al), tungsten (W), titanium (Ti), copper (Cu), or tantalum (Ta), but are not limited thereto.

The second circuit insulating layer 331 may include an insulating material. For example, the second circuit insulating layer 331 may include silicon oxide, but is not limited thereto.

Although not illustrated, the peripheral circuit structure PS may include an external connection pad positioned on the second circuit wiring layer 342, the second circuit wiring via 341, and the second circuit insulating layer 331. The external connection pad may include a conductive material. The peripheral circuit structure PS may be connected to an external device through the external connection pad.

The peripheral circuit structure PS may include the second connection pad 382 and the second pad insulating layer 381. The second connection pad 382 and the second pad insulating layer 381 may be positioned on the first circuit wiring layer 362, the first circuit wiring via 361, and the first circuit insulating layer 371. The peripheral circuit structure PS may include a plurality of second connection pads 382. The plurality of second connection pads 382 may be arranged spaced apart in a direction parallel to the first surface 300a of the substrate 300 for example, the first direction DR1. A second pad insulating layer 381 may be positioned between the plurality of second connection pads 382. The second pad insulating layer 381 may surround side surfaces of the plurality of second connection pads 382. The peripheral circuit structure PS may be bonded to the cell structure CS through the second connection pad 382 and the second pad insulating layer 381.

The first connection pad 282 of the cell structure CS is bonded to the second connection pad 382 of the peripheral circuit structure PS, and the first pad insulating layer 281 of the cell structure CS may be bonded to the second pad insulating layer 381 of the peripheral circuit structure PS. The first connection pad 282 and the second connection pad 382 may include a metal. For example, the first connection pad 282 and the second connection pad 382 may include copper (Cu). The first pad insulating layer 281 and the second pad insulating layer 381 may include an insulating material. Such bonding of the cell structure CS and the peripheral circuit structure PS may be referred to as hybrid bonding. Hybrid bonding may refer to bonding in which bonding between metal layers and bonding between insulating layers are performed simultaneously. When the first connection pad 282 and the second connection pad 382 include copper (Cu), such bonding of the cell structure CS and the peripheral circuit structure PS may be referred to as copper (Cu)-copper (Cu) hybrid bonding. However, the bonding method of the cell structure CS and the peripheral circuit structure PS is not limited thereto, and may be variously modified.

In some embodiments, as illustrated in FIG. 3, the cell structure CS may include one cell array region CAR. In embodiments, the cell structure CS may include a plurality of cell array regions CAR. In plan view, the cell array region CAR of the cell structure CS may overlap at least a part of the core periphery region CPR of the peripheral circuit structure PS. As the cell structure CS and the peripheral circuit structure PS are stacked in the third direction DR3, the cell array region CAR may overlap with the core periphery region CPR in the third direction DR3. In FIG. 3, it is illustrated that the shape and size (for example, area) of the core periphery region CPR and the cell array region CAR are the same, however, it is not limited thereto. For example, the shape of the core periphery region CPR may have a shape including the cell array region CAR, and the size (for example, area) of the core periphery region CPR may be larger than the size of the cell array region CAR.

Hereinafter, the bit line BL, word line WL, active pattern AP, and capacitor DSP included in the cell structure CS will be described in detail.

A semiconductor device according to embodiments may include the bit line BL extending in the first direction DR1. The first direction DR1 may be a direction parallel to the first surface 300a of the substrate 300. A semiconductor device according to embodiments may include a plurality of bit lines BL. The plurality of bit lines BL may be arranged spaced apart in the second direction DR2 intersecting the first direction DR1. The second direction DR2 may be a direction parallel to the first surface 300a of the substrate 300. For example, the second direction DR2 may be a direction orthogonal to the first direction DR1. The plurality of bit lines BL may be arranged spaced apart in the first direction DR1. In embodiments, the plurality of bit lines BL may be arranged spaced apart in the first direction DR1 and the second direction DR2.

The bit line BL (BL1, BL2) may include a polysilicon layer 161 (161_1, 161_2) and a metal layer 163 (163_1, 163_2) sequentially stacked. The polysilicon layer 161 may include polysilicon doped with an impurity. The metal layer 163 may include a metal, a conductive metal nitride, a conductive metal silicide, or a combination thereof. The metal may include, for example, tungsten, titanium, or tantalum, but is not limited thereto. The conductive metal nitride may include, for example, titanium nitride or tantalum nitride, but is not limited thereto. The conductive metal silicide may include, for example, titanium silicide, cobalt silicide, or nickel silicide, but is not limited thereto.

For example, the bit line BL may include a two-dimensional material or a three-dimensional material. For example, the two-dimensional material may include graphene, but is not limited thereto. For example, the three-dimensional material may include carbon nanotubes, but is not limited thereto.

A semiconductor device according to embodiments may include a bit line capping layer 165 positioned on the bit line BL. The bit line capping layer 165 may be positioned on the metal layer 163. A semiconductor device according to embodiments may include a plurality of bit line capping layers 165. The plurality of bit line capping layers 165 may be positioned on the plurality of bit lines BL, respectively. As the plurality of bit lines BL are spaced apart and arranged along the first direction DR1 and the second direction DR2, the plurality of bit line capping layers 165 may also be spaced apart and may be arranged along the first direction DR1 and the second direction DR2.

The bit line capping layer 165 may include an insulating material. For example, the bit line capping layer 165 may include silicon nitride or silicon oxynitride, but is not limited thereto.

The bit line capping layer 165 may be covered by the cell insulating layer 251. The cell insulating layer 251 may cover the upper surface of the bit line capping layer 165.

A semiconductor device according to embodiments may include the word line WL positioned on the lower surface of the bit line BL and extending in the second direction DR2. A semiconductor device according to embodiments may include a plurality of word lines WL. The plurality of word lines WL may be spaced apart and may be arranged in the first direction DR1. The plurality of word lines WL may include a pair of word lines WL1, WL2. The pair of word lines WL1, WL2 may include a first word line WL1 and a second word line WL2 spaced apart in the first direction DR1 between two active patterns AP adjacent in the first direction DR1.

The word line WL may include a conductive material. For example, the word line WL may include metal, conductive metal nitride, conductive metal silicide, or a combination thereof.

A semiconductor device according to embodiments may include a first gate capping pattern 143 and a second gate capping pattern 147 positioned on both side surfaces in the third direction DR3 of the word line WL. The first gate capping pattern 143 may be positioned between the word line WL and the storage contact BC, which will be described later. The second gate capping pattern 147 may be positioned between the word line WL and the bit line BL. The word line WL and the storage contact BC may be spaced apart in the third direction DR3 by the first gate capping pattern 143. The word line WL and the bit line BL may be spaced apart in the third direction DR3 by the second gate capping pattern 147. The first gate capping pattern 143 and the second gate capping pattern 147 may include an insulating material.

The first gate capping pattern 143 and the second gate capping pattern 147 may include an insulating material. For example, the first gate capping pattern 143 and the second gate capping pattern 147 may each include silicon nitride, but are not limited thereto.

A semiconductor device according to embodiments may include a gate separation pattern 141 positioned between the pair of word lines WL1, WL2. The gate separation pattern 141 may be positioned on side surfaces of the pair of word lines WL1, WL2 facing each other in the first direction DR1. The first word line WL1 and the second word line WL may be separated by the gate separation pattern 141. The gate separation pattern 141 may include an insulating material.

For example, a lower surface of the gate separation pattern 141 may be positioned at substantially the same level as a lower surface of the word line WL. A lower surface of the gate separation pattern 141 may be positioned at substantially the same level as an upper surface of the first gate capping pattern 143. An upper surface of the gate separation pattern 141 may be positioned at a higher level than an upper surface of the word line WL. For example, an upper surface of the gate separation pattern 141 may be positioned at the same level as an upper surface of the second gate capping pattern 147. However, the embodiments are not limited thereto. The positional relationship among the gate separation pattern 141, the word line WL, the first gate capping pattern 143, and the second gate capping pattern 147 may be variously changed.

A semiconductor device according to embodiments may include the active pattern AP extending in the third direction DR3 that is intersecting the first direction DR1 and the second direction DR2, from the lower surface of a bit line BL. For example, the third direction DR3 may be a direction substantially perpendicular to the first direction DR1 and the second direction DR2. One end portion of the active pattern AP in the third direction DR3 may be connected to the bit line BL. The other end portion of the active pattern AP in the third direction DR3 may be connected to the capacitor DSP. A storage contact BC and a landing pad LP, which will be described later, may be positioned between the active pattern AP and the capacitor DSP.

The active pattern AP may overlap with the word line WL in the first direction DR1. A semiconductor device according to embodiments may include the gate insulating pattern Gox positioned between the active pattern AP and the word line WL. The gate insulating pattern Gox may be positioned on the side surface of the active pattern AP in the first direction DR1. The gate insulating pattern Gox may also be positioned between the active pattern AP and the first gate capping pattern 143, and between the active pattern AP and the second gate capping pattern 147. The length of the gate insulating pattern Gox in the third direction DR3 may be substantially the same as the length of the active pattern AP in the third direction DR3.

The gate insulating pattern Gox may include silicon oxide, silicon oxynitride, a high dielectric constant material having a higher dielectric constant than silicon oxide, or a combination thereof. For example, the high dielectric constant material may include any one of HfO₂, HfSiO, HfSiON, HfTaO, HfTiO, HfZrO, ZrO₂, Al₂O₃, or a combination thereof, but is not limited thereto.

A semiconductor device according to embodiments may include a plurality of active patterns AP. The plurality of active patterns AP may be spaced apart and may be arranged in the first direction DR1. The plurality of active patterns AP may be spaced apart and may be arranged in the second direction DR2.

The plurality of active patterns AP may include a first active pattern AP1 and a second active pattern AP2. The first active pattern AP1 and the second active pattern AP2 may be spaced apart and may be positioned in the first direction DR1 between two adjacent pairs of word lines WL1, WL2 in the first direction DR1. The first active pattern AP1 and the second active pattern AP2 may be positioned between the first word line WL1 and the second word line WL2, and the first word line WL1 and the second word line WL2 may be included in two adjacent pairs, respectively.

The active pattern AP may include a semiconductor material. For example, the active pattern AP may include single crystal silicon, but is not limited thereto. Both end portions of the active pattern AP in the third direction DR3 may include a p-type or n-type dopant. As a voltage equal to or greater than a threshold voltage is applied to the word line WL, a channel may be formed in a region of the active pattern AP overlapping the word line WL. The channel may extend in the third direction DR3 along the shape of the active pattern AP. Accordingly, the transistor configuring the memory cell may be a vertical channel transistor.

A semiconductor device according to embodiments may include the capacitor DSP positioned on a lower surface of the active pattern AP. A semiconductor device according to embodiments may include a storage contact BC and a landing pad LP positioned between the lower surface of the capacitor DSP and the active pattern AP. A semiconductor device according to embodiments may include a plurality of capacitors DSP. The plurality of capacitors DSP may be positioned on the lower surfaces of the plurality of active patterns AP, respectively. A semiconductor device according to embodiments may include a plurality of storage contacts BC and a plurality of landing pads LP positioned between the plurality of capacitors DSP and the lower surfaces of the plurality of active patterns AP.

The storage contact BC, the landing pad LP, and the capacitor DSP may be sequentially stacked on the lower surface of the active pattern AP. The storage contact BC may overlap the active pattern AP, the gate insulating pattern Gox, and the first gate capping pattern 143 in the third direction DR3. The storage contact BC may not overlap with a first back gate capping pattern 116, which will be described later, in the third direction DR3, but is not limited thereto. For example, the storage contact BC may overlap with the first back gate capping pattern 116 in the third direction DR3. The storage contact BC may have a circular shape in plan view, but is not limited thereto, and may have various shapes such as an elliptical, rectangular, square, rhombic, or hexagonal shape.

The storage contact BC may include a conductive material. For example, the storage contact BC may include doped polysilicon, metal, conductive metal nitride, conductive metal silicon nitride, conductive metal carbonitride, conductive metal silicide, conductive metal oxide, conductive two-dimensional material, or a combination thereof.

The landing pad LP may be positioned on the storage contact BC. The plurality of landing pads LP may be positioned on the plurality of storage contacts BC, respectively. The plurality of landing pads LP may be spaced apart and may be arranged along in first direction DR1 and in second direction DR2. The plurality of landing pads LP may be arranged in a matrix shape.

The landing pad LP may be overlapped with the storage contact BC and in the third direction DR3. The landing pad LP may have a circular shape in plan view, however, it is not limited thereto and may have various shapes such as an elliptical, rectangular, square, rhombic, or hexagonal shape.

The landing pad LP may include a conductive material. For example, the storage contact BC may include doped polysilicon, metal, conductive metal nitride, conductive metal silicon nitride, conductive metal carbonitride, conductive metal silicide, conductive metal oxide, conductive two-dimensional material, or a combination thereof.

A semiconductor device according to embodiments may include a contact separation insulating layer 145 positioned between the plurality of storage contacts BC. The contact separation insulating layer 145 may be positioned between the plurality of landing pads LP. The contact separation insulating layer 145 may surround side surfaces of the plurality of storage contacts BC. The contact separation insulating layer 145 may surround side surfaces of the plurality of landing pads LP.

The contact separation insulating layer 145 may include an insulating material. For example, the contact separation insulating layer 145 may include silicon nitride, but is not limited thereto. The contact separation insulating layer 145 is illustrated as a single layer; however, it is not limited thereto and may be formed as a multilayer. For example, the contact separation insulating layer 145 may include an insulating layer surrounding the side surfaces of the plurality of storage contacts BC and an insulating layer surrounding the side surfaces of the plurality of landing pads LP.

The capacitor DSP may be positioned on the landing pad LP. The plurality of capacitors DSP may be positioned on the plurality of landing pads LP, respectively. The plurality of capacitors DSP may be spaced apart and may be arranged along the first direction DR1 and the second direction DR2. The plurality of capacitors DSP may be arranged in a matrix form.

The capacitor DSP may overlap the landing pad LP in the third direction DR3. The capacitor DSP may be connected to the active pattern AP through the landing pad LP and the storage contact BC. In FIG. 4, the capacitor DSP is illustrated as being connected to the storage contact BC via the landing pad LP, but is not limited thereto. According to embodiments, the landing pad LP may be omitted. When the landing pad LP is omitted, the capacitor DSP may be directly connected to the storage contact BC.

The capacitor DSP may include a first electrode 181, a second electrode 185, and a dielectric layer 183 positioned between the first electrode 181 and the second electrode 185. The first electrode 181 may be connected to the landing pad LP. The first electrode 181 may extend in the third direction DR3 on the landing pad LP. The dielectric layer 183 may extend along the profile of the lower surface and side surface of the first electrode 181. The dielectric layer 183 may cover the lower surface and side surface of the first electrode 181 with a uniform thickness. The dielectric layer 183 may also be positioned on the lower surface of the contact separation insulating layer 145. The second electrode 185 may be positioned on the dielectric layer 183. The second electrode 185 may cover the lower surface and side surface of the first electrode 181. A plurality of first electrodes 181 of the plurality of capacitors DSP may be spaced apart from each other. The dielectric layer 183 and the second electrode 185 of the plurality of capacitors DSP may be integrally connected.

The plurality of capacitors DSP may be covered by the cell insulating layer 251. The cell insulating layer 251 may cover the lower surface and side surface of the second electrode 185 of the plurality of capacitors DSP.

The first electrode 181 and the second electrode 185 may include a conductive material. The first electrode 181 may include a metal, a conductive metal nitride, or a combination thereof. For example, the first electrode 181 may include TiN, Ru, TaN, WN, Pt, Ir, or a combination thereof. The second electrode 185 may include a metal, a conductive metal nitride, a metal silicide, or a combination thereof. For example, the second electrode 185 may include W, Ti, Ru, or SiGe. However, the materials included in the first electrode 181 and the second electrode 185 are not limited thereto, and may be variously modified.

The dielectric layer 183 may include tantalum oxide (Ta₂O₅), aluminum oxide (Al₂O₃), titanium oxide (TiO₂), or a combination thereof. However, the material included in the dielectric layer 183 is not limited thereto, and may be variously changed.

A semiconductor device according to embodiments may include the back gate electrode BG positioned between the first active pattern AP1 and the second active pattern AP2 and extending in the second direction DR2. A semiconductor device according to embodiments may include a plurality of back gate electrodes BG. The plurality of back gate electrodes BG may be spaced apart and may be arranged in the first direction DR1. Each of the plurality of back gate electrodes BG may be positioned between the first active pattern AP1 and the second active pattern AP2, and may extend in the second direction DR2.

In the first direction DR1, the first active pattern AP1 may be positioned between the first word line WL1 and the back gate electrode BG. In the first direction DR1, the second active pattern AP2 may be positioned between the second word line WL2 and the back gate electrode BG.

The back gate electrode BG may overlap the word line WL in the first direction DR1. The entirety of the back gate electrode BG may overlap with the word line WL. The back gate electrode BG may overlap with the region of the active pattern AP overlapping the word line WL. An upper surface of the back gate electrode BG in the third direction DR3 may be positioned at substantially the same level as an upper surface of the word line WL in the third direction DR3. A lower surface of the back gate electrode BG in the third direction DR3 may be positioned at a higher level than a lower surface of the word line WL in the third direction DR3. In this case, the length of the back gate electrode BG in the third direction DR3 may be shorter than the length of the word line WL in the third direction DR3, but is not limited thereto. The positional relationship and length of the back gate electrode BG and the word line WL may be variously changed.

The width of the back gate electrode BG in the first direction DR1 may be greater than the width of the word line WL in the first direction DR1. However, embodiments are not limited thereto. The widths of the back gate electrode BG and the word line WL may be variously changed.

The back gate electrode BG may include a conductive material. For example, the back gate electrode BG may include doped polysilicon, metal, conductive metal nitride, conductive metal silicon nitride, conductive metal carbonitride, conductive metal silicide, conductive metal oxide, conductive two-dimensional material, or a combination thereof.

A semiconductor device according to embodiments may include a first back gate capping pattern 116 and a second back gate capping pattern 149 respectively positioned on both side surfaces in the third direction DR3 of the back gate electrode BG. The first back gate capping pattern 116 may be positioned between the back gate electrode BG and the contact separation insulating layer 145. The second back gate capping pattern 149 may be positioned between the back gate electrode BG and the bit line BL. The back gate electrode BG and the contact separation insulating layer 145 may be spaced apart in the third direction DR3 by the first back gate capping pattern 116. The back gate electrode BG and the bit line BL may be spaced apart in the third direction DR3 by the second back gate capping pattern 149.

The first back gate capping pattern 116 and the second back gate capping pattern 149 may include an insulating material. For example, the first back gate capping pattern 116 may include silicon oxide, but is not limited thereto. For example, the second back gate capping pattern 149 may include silicon nitride, but is not limited thereto.

For example, the second back gate capping pattern 149 may be formed simultaneously with the second gate capping pattern 147 in the same process. In this case, the second back gate capping pattern 149 and the second gate capping pattern 147 may include the same material. However, embodiments are not limited thereto. For example, the second back gate capping pattern 149 and the second gate capping pattern 147 may include different materials.

A semiconductor device according to embodiments may include the back gate insulating pattern BGox positioned between the active pattern AP and the back gate electrode BG. The back gate insulating pattern BGox may be positioned on the side surface of the active pattern AP in the first direction DR1. The gate insulating pattern Gox is positioned on one side surface of the active pattern AP in the first direction DR1, and the back gate insulating pattern BGox may be positioned on the other side surface of the active pattern AP in the first direction DR1. The back gate insulating pattern BGox may also be positioned between the active pattern AP and the first back gate capping pattern 116, and between the active pattern AP and the second back gate capping pattern 149. The length of the back gate insulating pattern BGox in the third direction DR3 may be substantially the same as the length of the active pattern AP in the third direction DR3.

The back gate insulating pattern BGox may include silicon oxide, silicon oxynitride, a high dielectric constant material having a higher dielectric constant than silicon oxide, or a combination thereof. For example, the high dielectric constant material may include any one of HfO₂, HfSiO, HfSiON, HfTaO, HfTiO, HfZrO, ZrO₂, Al₂O₃, or a combination thereof, but is not limited thereto.

The back gate insulating pattern BGox and the gate insulating pattern Gox may include the same material, however, they are not limited thereto. The back gate insulating pattern BGox and the gate insulating pattern Gox may include different materials.

A semiconductor device according to embodiments includes the back gate electrode BG, but embodiments are not limited thereto. According to embodiments, the back gate electrode BG may be omitted.

A semiconductor device according to embodiments may include the first cell wiring layer 262 positioned on the upper surface of the bit line BL. The first cell wiring layer 262 may be positioned on the bit line capping layer 165. The cell insulating layer 251 may be positioned between the first cell wiring layer 262 and the bit line capping layer 165.

A semiconductor device according to embodiments may include the bit line contact BLC connecting the first cell wiring layer 262 and the bit line BL. The bit line contact BLC may penetrate the cell insulating layer 251 and the bit line capping layer 165 in the third direction DR3, and may be connected to the bit line BL. The bit line contact BLC may be connected to an upper surface of the metal layer 163 of the bit line BL. The bit line contact BLC may overlap the capacitor DSP in the third direction DR3.

A semiconductor device according to embodiments may include a plurality of bit line contacts BLC. The plurality of bit line contacts BLC may respectively connect between the plurality of bit lines BL and the first cell wiring layer 262. The plurality of bit lines BL may overlap the plurality of capacitors DSP in the third direction DR3.

A semiconductor device according to embodiments may include a bit line insulating pattern 167 positioned between the plurality of bit lines BL adjacent in the first direction DR1. The bit line insulating pattern 167 may be positioned between the plurality of bit line capping layers 165 adjacent in the first direction DR1.

The bit line insulating pattern 167 may overlap, in the second direction DR2, with a bit line BL adjacent to two bit lines BL respectively positioned on both sides of the bit line insulating pattern 167 in the first direction DR1. A portion of the bit line BL overlapping the bit line insulating pattern 167 in the second direction DR2 may be a portion to which the bit line contact BLC is connected.

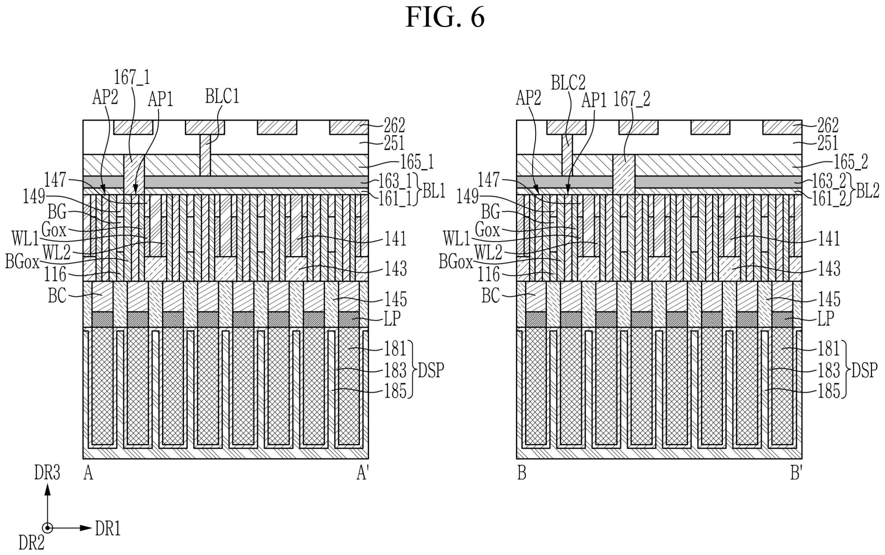

The bit line insulating pattern 167 may overlap, in the third direction DR3, with the pair of word lines WL1, WL2 positioned between two active patterns AP adjacent in the first direction DR1. The bit line insulating pattern 167 may overlap with the gate separation pattern 141 positioned between the pair of word lines WL1, WL2 in the third direction DR3. In contrast, the bit line insulating pattern 167 may not overlap with the active pattern AP in the third direction DR3. In this case, since each of the plurality of active patterns AP spaced apart in the first direction DR1 is connected to the bit line BL, all active patterns AP spaced apart in the first direction DR1 may be effectively used. However, embodiments are not limited thereto, and the position of the bit line insulating pattern 167 according to the overlap relationship in the third direction DR3 may be variously changed. Embodiments related thereto will be described hereinafter with reference to FIG. 6.

A semiconductor device according to embodiments may include a plurality of bit line insulating patterns 167. The plurality of bit line insulating patterns 167 may be spaced apart and may be arranged along the first direction DR1. The plurality of bit line insulating patterns 167 may be spaced apart and may be arranged along the second direction DR2. The plurality of bit line insulating patterns 167 spaced apart and arranged in the second direction DR2 may be arranged staggered along the second direction DR2. The plurality of bit line insulating patterns 167 spaced apart and arranged in the second direction DR2 may be arranged in a zigzag manner along the second direction DR2. Odd-numbered bit line insulating patterns 167 among the plurality of bit line insulating patterns 167 arranged spaced apart in the second direction DR2 may be aligned along the second direction DR2. Even-numbered bit line insulating patterns 167 among the plurality of bit line insulating patterns 167 arranged spaced apart in the second direction DR2 may be aligned along the second direction DR2. The bit line BL may be positioned between odd-numbered bit line insulating patterns 167 adjacent to each other in the second direction DR2. The bit line BL may be positioned between bit line insulating patterns 167 of even-numbered positions that are adjacent in the second direction DR2.

As described above, the plurality of bit line insulating patterns 167 may include a bit line insulating pattern 167 positioned between the plurality of bit lines BL spaced apart in the first direction DR1. The plurality of bit line insulating patterns 167 may include the bit line insulating pattern 167 positioned at one side of the bit line BL positioned at an end in the first direction DR1 among the plurality of bit lines BL spaced apart in the first direction DR1. The plurality of bit lines BL and the plurality of bit line insulating patterns 167 may be arranged alternately and repeatedly in the first direction DR1, and the bit line BL and the bit line insulating pattern 167 may be positioned respectively at both ends in the first direction DR1.

The bit line insulating pattern 167 may include an insulating material. For example, the bit line insulating pattern 167 may include silicon nitride, but is not limited thereto. The bit line insulating pattern 167 and the bit line capping layer 165 may include the same material. In this case, the interface between the bit line insulating pattern 167 and the bit line capping layer 165 may not be visually identified. However, the embodiments are not limited thereto. For example, the bit line insulating pattern 167 and the bit line capping layer 165 may include different materials.

Referring to FIG. 3, the plurality of bit lines BL may include a plurality of first bit lines BL1 and a plurality of second bit lines BL2 adjacent in the second direction DR2. The plurality of first bit lines BL1 may be spaced apart and may be arranged in the first direction DR1. The plurality of second bit lines BL2 may be spaced apart and may be arranged in the first direction DR1. The plurality of first bit lines BL1 and the plurality of second bit lines BL2 may be arranged staggered in the second direction DR2. The first bit line BL1 and the second bit line BL2 adjacent in the second direction DR2 may be arranged to be staggered in the second direction DR2. The fact that the first bit line BL1 and the second bit line BL2 are arranged to be staggered in the second direction DR2 may mean that the center of the first bit line BL1 and the center of the second bit line BL2 are not positioned on the same line extending in the second direction DR2. It may mean that the side surface of the first bit line BL1 in the first direction DR1 and the side surface of the second bit line BL2 in the first direction DR1 are not positioned on the same line extending in the second direction DR2.

The plurality of bit line insulating patterns 167 may include a plurality of first bit line insulating patterns 167_1 alternately and repeatedly arranged with the plurality of first bit lines BL1 along the first direction DR1, and a plurality of second bit line insulating patterns 167_2 alternately and repeatedly arranged with the plurality of second bit lines BL2 along the first direction DR1. The plurality of first bit line insulating patterns 167_1 may be arranged alternately and repeatedly with the plurality of second bit lines BL2 along the second direction DR2. The plurality of second bit line insulating patterns 167_2 may be arranged alternately and repeatedly with the plurality of first bit lines BL1 along the second direction DR2.

The plurality of bit line capping layers 165 may include a first bit line capping layer 165_1 positioned on the plurality of first bit lines BL1 and a second bit line capping layer 165_2 positioned on the plurality of second bit lines BL2. The plurality of first bit line insulating patterns 167_1 may be arranged alternately and repeatedly with the plurality of first bit line capping layers 165_1 along the first direction DR1. The plurality of second bit line insulating patterns 167_2 may be arranged alternately and repeatedly with the plurality of second bit line capping layers 165_2 along the first direction DR1.

The plurality of first bit lines BL1 and the plurality of first bit line insulating patterns 167_1 may be arranged alternately and repeatedly in the first direction DR1. For example, the first bit line BL1 may be positioned at one end in the first direction DR1. At the other end in the first direction DR1, the first bit line insulating pattern 167_1 may be positioned.

The plurality of second bit lines BL2 and the plurality of second bit line insulating patterns 167_2 may be arranged alternately and repeatedly in the first direction DR1. For example, at one end in the first direction DR1, the second bit line insulating pattern 167_2 may be positioned. At the other end in the first direction DR1, the second bit line BL2 may be positioned.

The plurality of first bit lines BL1 may overlap in the second direction DR2 with the plurality of second bit line insulating patterns 167_2 positioned between the plurality of second bit lines BL2. The plurality of second bit lines BL2 may overlap with the plurality of first bit line insulating patterns 167_1 positioned between the plurality of first bit lines BL in the second direction DR2.

The first bit line BL1 positioned at the end in the first direction DR1 among the plurality of first bit lines BL1 may overlap the second bit line insulating pattern 167_2 in the second direction DR2. The second bit line insulating pattern 167_2 overlapping the first bit line BL1 positioned at an end in the first direction DR1 may be positioned at one end in the first direction DR1.

The second bit line BL2 positioned at an end in the first direction DR1 among the plurality of second bit lines BL2 may overlap the first bit line insulating pattern 167_1 in the second direction DR2. The first bit line insulating pattern 167_1 overlapping the second bit line BL2 positioned at an end in the first direction DR1 may be positioned at the other end in the first direction DR1.

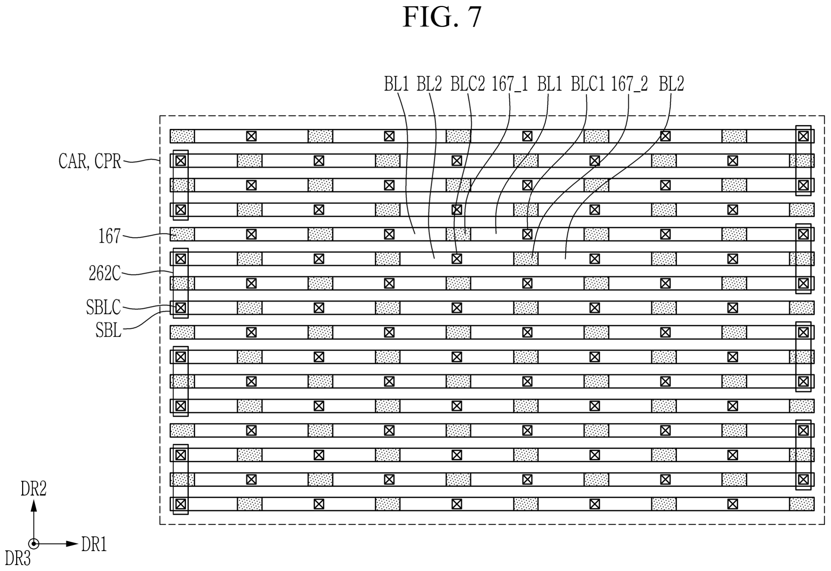

In embodiments, the bit line contact BLC may be connected to an end portion of the bit line BL in the first direction DR1. However, embodiments are not limited thereto. For example, as shown in FIG. 7, the bit line contact BLC may be connected to the central portion of the bit line BL in the first direction DR1. Alternatively, the bit line contact BLC may be connected to a portion between the center portion of the bit line BL and the end of the bit line BL in the first direction DR1. That is, the position of the bit line contact BLC connected portion on the bit line BL in the first direction DR1 may be variously changed. Hereinafter, description will be made mainly on a case where the bit line contact BLC is connected to an end portion of the bit line BL, but the following description may be equally or similarly applied to a case where the bit line contact BLC is connected to another portion of the bit line BL.

The plurality of bit line contacts BLC may include a first bit line contact BLC1 connected to the first bit line BL1 and a second bit line contact BLC2 connected to the second bit line BL2. For example, the first bit line contact BLC1 is connected to one end portion of the first bit line BL1 in the first direction DR1, and the second bit line contact BLC2 may be connected to the other end portion of the second bit line BL2 in the first direction DR1.

A portion of the first bit line BL1 overlapping with the second bit line insulating pattern 167_2 in the second direction DR2 may be a portion where the first bit line contact BLC1 is connected to the first bit line BL1. For example, the second bit line insulating pattern 167_2 may overlap in the second direction DR2 with one end portion of the first bit line BL1 in the first direction DR1.

A portion of the second bit line BL2 overlapping the first bit line insulating pattern 167_1 in the second direction DR2 may be a portion where a second bit line contact BLC2 is connected to the second bit line BL2. For example, the first bit line insulating pattern 167_1 may overlap in the second direction DR2 with the other end portion of the second bit line BL2 in the first direction DR1.

A semiconductor device according to embodiments may include the bit line insulating pattern 167 positioned between two bit lines BL adjacent in the first direction DR1. The bit line insulating pattern 167 may overlap the bit line BL in the second direction DR2. The bit line BL overlapping with the bit line insulating pattern 167 in the second direction DR2 may be adjacent, in the second direction DR2, to two bit lines BL respectively positioned at both sides of the bit line insulating pattern 167 in the first direction DR1. A portion of the bit line BL overlapping with the bit line insulating pattern 167 in the second direction DR2 may be a portion where the bit line contact BLC is connected. Accordingly, when forming the bit line contact BLC on the bit line BL, misalignment may be prevented, thereby preventing the bit line contact BLC from being formed on another bit line BL that is adjacent to the bit line BL in the second direction DR2. Accordingly, it may be possible to improve the data transmission reliability of the semiconductor device.

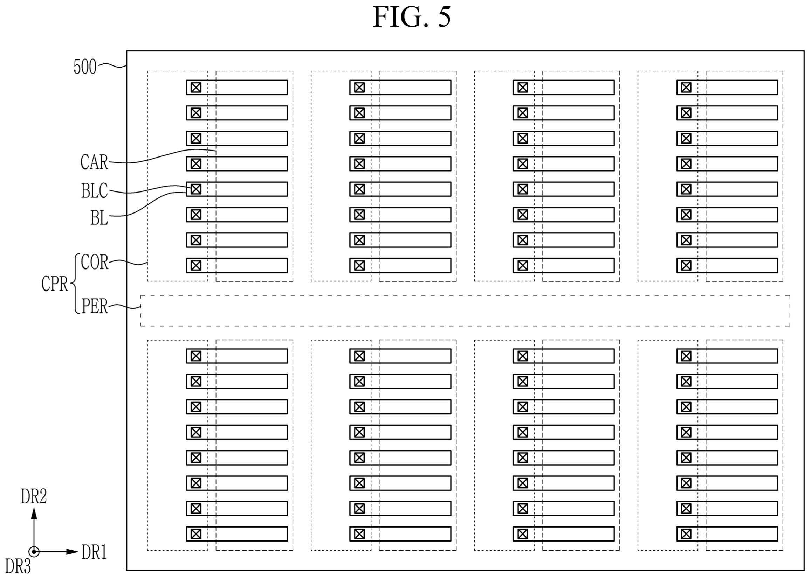

Hereinafter, the effects of the semiconductor device according to the embodiments shown in FIGS. 1 to 4 will be further explained in comparison with the comparative example shown in FIG. 5.

FIG. 5 is a plan view illustrating a part of a semiconductor device according to a comparative example. FIG. 5 is a view showing a configuration in which a plurality of bit lines are arranged in a semiconductor device according to a comparative example. For convenience, only the substrate 500, the bit line BL, and the bit line contact BLC are shown, and illustration of other components is omitted.

According to the comparative example, the substrate 500 may include a plurality of cell array regions CAR and a core periphery region CPR surrounding the plurality of cell array regions CAR. The plurality of cell array regions CAR may be arranged spaced apart along the first direction DR1 and the second direction DR2. The first direction DR1 may be the extending direction of the bit line BL. The second direction DR2 may be an intersecting direction with the first direction DR1. For example, the second direction DR2 may be a direction perpendicular to the first direction DR1.

The core periphery region CPR may include a core region COR and a periphery region PER. The core region COR may be positioned at one side of each of the plurality of cell array regions CAR. The core region COR may be positioned at one side of each cell array region CAR along the first direction DR1. The periphery region PER may be positioned between the plurality of cell array regions CAR. The periphery region PER may be positioned between the plurality of cell array regions CAR spaced apart in the second direction DR2.

According to the comparative example, the plurality of cell array regions CAR and core periphery regions CPR may be arranged in a parallel direction on the substrate 500. The bit line BL positioned on each cell array region CAR may be connected to a wiring layer connected to a core circuit (for example, a sense amplifier) positioned on the core region COR. In this case, the end portion of the bit line BL in the first direction DR1 may be extended to the outside of the cell array region CAR and may also be positioned on the core region COR. An end portion of the bit line BL in the first direction DR1 may be connected to the wiring layer connected to the core circuit through the bit line contact BLC. Accordingly, the bit line contact BLC is not positioned on the cell array region CAR, but may be positioned on the core region COR. The bit line contact BLC may be positioned outside the cell array region CAR as the bit line contact BLC is connected to the bit line BL outside the cell array region CAR.

In addition, as the cell array region CAR and the core periphery region CPR are arranged on the substrate 300 in a parallel direction, the core region COR is positioned between the plurality of bit lines BL spaced apart in the first direction DR1, and the periphery region PER may be positioned between the plurality of bit lines BL spaced apart in the second direction DR2. Accordingly, a region in which the plurality of bit lines spaced apart in the first direction DR1 are positioned may be divided into different cell array regions CAR. In addition, a region in which the plurality of bit lines spaced apart in the second direction DR2 are positioned may be divided into different cell array regions CAR. In other words, the substrate 300 may include the plurality of cell array regions CAR.

In contrast, according to the embodiments shown in FIGS. 1 to 4, the cell array region CAR and the core periphery region CPR may overlap in the third direction DR3 perpendicular to the substrate 300. The bit line BL of the cell structure CS may be connected to the peripheral circuit structure PS through a wiring layer. The wiring layer may include the first circuit wiring layer 362 of the peripheral circuit structure PS, and the first cell wiring layer 262 included in the cell structure CS, which is connected to the first circuit wiring layer 362. The first circuit wiring layer 362 and the first cell wiring layer 262 may be overlapped in the third direction DR3 perpendicular to the substrate 300. In this case, the bit line BL may be connected to the first cell wiring layer 262 through the bit line contact BLC. Accordingly, the bit line contact BLC may be positioned, in plan view, at the inner side of the cell array region CAR and the core periphery region CPR. The bit line contact BLC may be positioned inside the cell array region CAR, as the bit line contact BLC is connected to the bit line BL inside the cell array region CAR.

In addition, as the cell array region CAR and the core periphery region CPR are positioned to overlap in the third direction DR3 perpendicular to the substrate 300, the core periphery region CPR may not be positioned between the plurality of bit lines BL spaced apart in the first direction DR1 and the second direction DR2. Accordingly, a region in which the plurality of bit lines BL spaced apart in the first direction DR1 and the second direction DR2 are positioned may not be divided into different cell array regions CAR. In other words, a region in which the plurality of bit lines BL spaced apart in the first direction DR1 and the second direction DR2 are positioned may be constituted by a single cell array region CAR.

According to the embodiments shown in FIGS. 1 to 4, the cell array region CAR and the core periphery region PER are overlapped in the third direction DR3 perpendicular to the substrate 300, and since the bit line contact BLC is positioned inside the cell array region CAR, the area of the semiconductor device in plan view may be reduced compared to the comparative example. Accordingly, the integration density of the semiconductor device may be increased. For example, in a vertical channel transistor with a PoC (peri on cell) or CoP (cell on peri) structure, the bit line contact is located within the cell block and the bit line adjacent to the bit line contact is trimmed. According to this arrangement, the bit line contact can be prevented from connecting to the other bit line, and compared to when the cell and periphery are arranged horizontally, the substrate area occupied by the semiconductor device can be reduced, thereby improving the integration density of the semiconductor device.

Hereinafter, with reference to FIG. 6, a modified example of the embodiments shown in FIGS. 1 to 4 will be described.

FIG. 6 shows cross-sectional views taken along the A-A' line and B-B' line of FIG. 3. For the components of embodiments shown in FIG. 6 that are the same as the components of the embodiments shown in FIGS. 1 to 4, the same reference numerals may be referred to. Embodiments shown in FIG. 6 may have a position of the bit line insulating pattern 167 according to an overlap relationship in the third direction DR3 that is partially different from embodiments shown in FIGS. 1 to 4. Hereinafter, differences from the above-described embodiment will mainly be described, and redundant descriptions may be omitted or briefly provided.

In the embodiments illustrated in FIGS. 1 to 4, the bit line insulating pattern 167 (e.g. 167_1) may not overlap the active pattern AP in the third direction DR3. In contrast, in embodiments shown in FIG. 6, the bit line insulating pattern 167 may overlap, in the third direction DR3, with one of the plurality of active patterns AP spaced apart in the first direction DR1. The bit line insulating pattern 167 (167_1) may overlap, in the third direction DR3, the gate insulating pattern Gox and the back gate insulating pattern BGox which are respectively positioned on both sides of the active pattern AP in the first direction DR1. In this case, the active pattern AP overlapping with the bit line insulating pattern 167 in the third direction DR3 may not be effectively used, since it is not connected to the bit line BL.

For example, the closer to the bit line insulating pattern 167, the thickness of the bit line BL may become thinner. Here, the thickness of the bit line BL refers to the thickness in the third direction DR3. Accordingly, the thickness of the end portion of the bit line BL adjacent to the bit line insulating pattern 167 may be thinner than the thickness of the central portion of the bit line BL. Such reduction in thickness may deteriorate the electrical connection between the bit line BL and the active pattern AP. In embodiments shown in FIGS. 1 to 4, an end portion of the bit line BL adjacent to the bit line insulating pattern 167 may be positioned on the active pattern AP, and the thickness of the end of the bit line BL positioned on the active pattern AP may be thinner than the thickness of the central portion of the bit line BL. In this case, the active pattern AP may not be effectively used.

In addition, in the embodiments shown in FIGS. 1 to 4, both end portions of two bit lines BL respectively positioned on both sides of the bit line insulating pattern 167 may be positioned on the active pattern AP. Accordingly, with respect to one bit line insulating pattern 167, two active patterns AP may not be effectively used.

In contrast, in embodiments shown in FIG. 6, as the bit line insulating pattern 167 overlaps with one active pattern AP, one active pattern AP may not be effectively used with respect to one bit line insulating pattern 167. In some cases, the number of active patterns AP effectively used in embodiments shown in FIG. 6 may be greater than in the embodiments shown in FIGS. 1 to 4.

FIG. 7 is a plan view showing a part of a semiconductor device according to embodiments. For the components of embodiments shown in FIG. 7 that are the same as the components shown in the embodiments of FIGS. 1 to 4, the same reference numerals may be referred to. Embodiments shown in FIG. 7 may have a position where the bit line contact BLC is connected to the bit line BL that may differ somewhat from the embodiments shown in FIGS. 1 to 4. In addition, embodiments illustrated in FIG. 7 may be partially different from the embodiments shown in FIGS. 1 to 4 in that it further includes a short bit line SBL positioned at an end in the first direction DR1, a short bit line contact SBLC connected to the short bit line SBL, and a connection wiring 262C connecting two short bit lines SBL adjacent in the second direction DR2. Hereinafter, differences from the previous embodiment will be mainly described, and overlapping content may be omitted or briefly described.

FIG. 7 is a diagram illustrating a configuration in which a plurality of bit lines are arranged in a semiconductor device according to embodiments, and for convenience, only the bit line BL, bit line contact BLC, bit line insulating pattern 167, short bit line SBL, short bit line contact SBLC, and connection wiring 262C are illustrated, and depiction of other components is omitted.

In the embodiments shown in FIGS. 1 to 4, the bit line contact BLC may be connected to an end portion of the bit line BL in the first direction DR1. In contrast, in embodiments shown in FIG. 7, the bit line contact BLC may be connected to a central portion of the bit line BL in the first direction DR1. In this case, the bit line insulating pattern 167 may overlap, in the second direction DR2, with the central portion of the bit line BL to which the bit line contact BLC is connected. However, embodiments are not limited thereto. For example, the bit line contact BLC may be connected to a portion between the center portion of the bit line BL and the end portion of the bit line BL in the first direction DR1. That is, the position according to the first direction DR1 of the bit line BL to which the bit line contact BLC is connected may be variously changed. Hereinafter, description will be given mainly of a case where the bit line contact BLC is connected to the center portion of the bit line BL, but even in a case where the bit line contact BLC is connected to a portion between the center portion and the end portion of the bit line BL, only the length of the short bit line SBL differs, and the following description regarding the short bit line SBL may be applied identically or similarly.

In embodiments, the plurality of first bit lines BL1 spaced apart and arranged in the first direction DR1 and the plurality of second bit lines BL2 spaced apart and arranged in the first direction DR1 may be alternately and repeatedly arranged along the second direction DR2. The first bit line BL1 and the second bit line BL2 may be arranged staggered along the second direction DR2.

In embodiments, the bit line insulating pattern 167_1 may be positioned between the plurality of first bit lines BL1 spaced apart in the first direction DR1. The bit line insulating pattern 167_2 may be positioned between the plurality of second bit lines BL2 spaced apart in the first direction DR1. For example, the first bit line insulating pattern 167_1 may overlap, in the second direction DR2, with the central portion of the second bit line BL2 to which the second bit line contact BLC2 is connected. The second bit line insulating pattern 167_2 may be overlapped, in the second direction DR2, with the center portion of the first bit line BL1 to which the first bit line contact BLC1 is connected.

The bit line contact BLC is connected to the central portion of the bit line BL in the first direction DR1, and as the bit line insulating pattern 167 overlaps the central portion of the bit line BL in the second direction DR2, a length, in the first direction DR1, of the plurality of first bit lines BL1 and plurality of second bit lines BL2 overlapping in the second direction DR2 may be approximately half of the length, in the first direction DR1, of the bit line BL.

In the first direction DR1, a portion of the plurality of first bit lines BL1 positioned at one edge of the cell array region CAR overlaps with the plurality of second bit lines BL2 in the second direction DR2, and another portion of the plurality of first bit lines BL1 may protrude toward the one edge direction of the cell array region CAR along the first direction DR1 beyond the plurality of second bit lines BL2. A remaining space may occur at one side in the second direction DR2 of the portion of the plurality of first bit lines BL1 protruding toward the one edge direction of the cell array region CAR along the first direction DR1 beyond the plurality of second bit lines BL2.

In the first direction DR1, a portion of the plurality of second bit lines BL2 positioned at the other edge of the cell array region CAR overlaps with the plurality of first bit lines BL1 in the second direction DR2, and another portion of the plurality of second bit lines BL2 may protrude toward the other edge direction of the cell array region CAR along the first direction DR1 beyond the plurality of first bit lines BL1. A remaining space may occur at one side in the second direction DR2 of the portion of the plurality of second bit lines BL2 protruding toward the other edge direction of the cell array region CAR along the first direction DR1 beyond the plurality of first bit lines BL1.

According to the above, the length of the plurality of first bit lines BL1 and the plurality of second bit lines BL2 in the first direction DR1, which are overlapping in the second direction DR2, may be approximately half of the length of the bit line BL in the first direction DR1. Accordingly, the length of the remaining space in the first direction DR1 may also be approximately half the length of the bit line BL in the first direction DR1.

In embodiments illustrated in FIG. 7, the short bit line SBL having a length in the first direction DR1 shorter than the bit line BL may be arranged in the remaining space. For example, the length of the short bit line SBL in the first direction DR1 may be approximately half the length of the bit line BL in the first direction DR1. A semiconductor device according to embodiments may include the short bit line SBL positioned at one side of the plurality of bit lines BL in the first direction DR1. The short bit line SBL may protrude in a direction away from the plurality of bit lines BL in the first direction DR1 with respect to the bit line BL adjacent to the short bit line SBL in the second direction DR2. In other words, the short bit line SBL may be positioned at the edge of the cell array region CAR in the first direction DR1, and may protrude in the edge direction of the cell array region CAR in the first direction DR1 with respect to the bit line BL adjacent to the short bit line SBL in the second direction DR2.

A semiconductor device according to embodiments may include a plurality of short bit lines SBL spaced apart and arranged along the second direction DR2. The plurality of short bit lines SBL may be spaced apart and may be arranged along the second direction DR2 at one side in the first direction DR1 of the plurality of first bit lines BL1. The plurality of short bit lines SBL positioned at one side in the first direction DR1 of a plurality of first bit lines BL1 may be positioned between the plurality of second bit lines BL2 spaced apart in the second direction DR2. In addition, the plurality of short bit lines SBL may be spaced apart and may be arranged along the second direction DR2 at the other side in the first direction DR1 of the plurality of second bit lines BL2. The plurality of short bit lines SBL positioned at the other side in the first direction DR1 of the plurality of second bit lines BL2 may be positioned between the plurality of first bit lines BL1 spaced apart in the second direction DR2. In other words, the plurality of short bit lines SBL may be spaced apart and may be arranged along the second direction DR2 at respective both edges of the cell array region CAR in the first direction DR1.

The plurality of short bit lines SBL positioned at one edge of the cell array region CAR in the first direction DR1 may be positioned at one side in the second direction DR2 of portions of the plurality of first bit lines BL1 protruding beyond the plurality of second bit lines BL2 toward the one edge direction of the cell array region CAR in the first direction DR1. The plurality of short bit lines SBL positioned at one edge of the cell array region CAR in the first direction DR1 may protrude beyond the plurality of first bit lines BL1 toward the one edge direction of the cell array region CAR in the first direction DR1.

The plurality of short bit lines SBL positioned at the other edge of the cell array region CAR in the first direction DR1 may be positioned at one side in the second direction DR2 of portions of the plurality of second bit lines BL2 protruding beyond the plurality of first bit lines BL1 toward the other edge direction of the cell array region CAR in the first direction DR1. The plurality of short bit lines SBL positioned at the other end edge of the cell array region CAR in the first direction DR1 may protrude beyond the plurality of second bit lines BL2 toward the other edge direction of the cell array region CAR in the first direction DR1.

As described above, the length of the short bit line SBL in the first direction DR1 may be approximately half of the length of the bit line BL in the first direction DR1. In other words, the number of memory cells connected to each of the plurality of short bit lines SBL may be approximately half the number of memory cells connected to the bit line BL. Accordingly, in embodiments illustrated in FIG. 7, two short bit lines SBL adjacent in the second direction DR2 may be connected to each other and controlled as a single bit line BL.

The first cell wiring layer 262 of the semiconductor device according to embodiments may include the connection wiring 262C connecting two short bit lines SBL adjacent in the second direction DR2. A semiconductor device according to embodiments may include a short bit line contact SBLC connecting the connection wiring 262C and the short bit line SBL. The short bit line contact SBLC may be connected to the end portion of the short bit line SBL. The end portion of the short bit line SBL to which the short bit line contact SBLC is connected may be a portion distant from the plurality of bit lines BL in the first direction DR1. The end portion of the short bit line SBL to which the short bit line contact SBLC is connected may be adjacent to the edge of the cell array region CAR in the first direction DR1.

In embodiments, the plurality of bit line insulating patterns 167 may include the bit line insulating pattern 167 overlapping with the short bit line SBL in the second direction DR2. The bit line insulating pattern 167 may overlap with an end portion of the short bit line SBL, to which the short bit line contact SBLC is connected, in the second direction DR2. The bit line insulating pattern 167 overlapping with the short bit line SBL in the second direction DR2 may be positioned at the edge of the cell array region CAR in the first direction DR1. At both edges of the cell array region CAR in the first direction DR1, the plurality of short bit lines SBL and the plurality of bit line insulating patterns 167 may be alternately and repeatedly arranged along the second direction DR2.

For example, at the edge of the cell array region CAR in the first direction DR1, a remaining space positioned at one side in the second direction DR2 of each of the plurality of first bit lines BL1 and the plurality of second bit lines BL2 protruding in the edge direction of the cell array region CAR may occur. A semiconductor device according to embodiments may include the plurality of short bit lines SBL positioned in a remaining space at an edge in the first direction DR1 of the cell array region CAR. The short bit line SBL may have a length in the first direction DR1 that is shorter than the first bit line BL1 and the second bit line BL2. Two adjacent short bit lines SBL among the plurality of short bit lines SBL spaced apart in the second direction DR2 may be connected to each other by the connection wiring 262C. According to embodiments, it is possible to increase the number of memory cells positioned in the cell array region CAR, and accordingly, the integration density of the semiconductor device may increase.

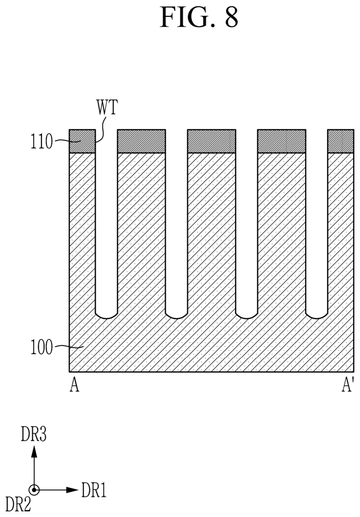

Hereinafter, the manufacturing method according to the embodiments shown in FIGS. 1 to 4 will be described with reference to FIGS. 8 to 20.

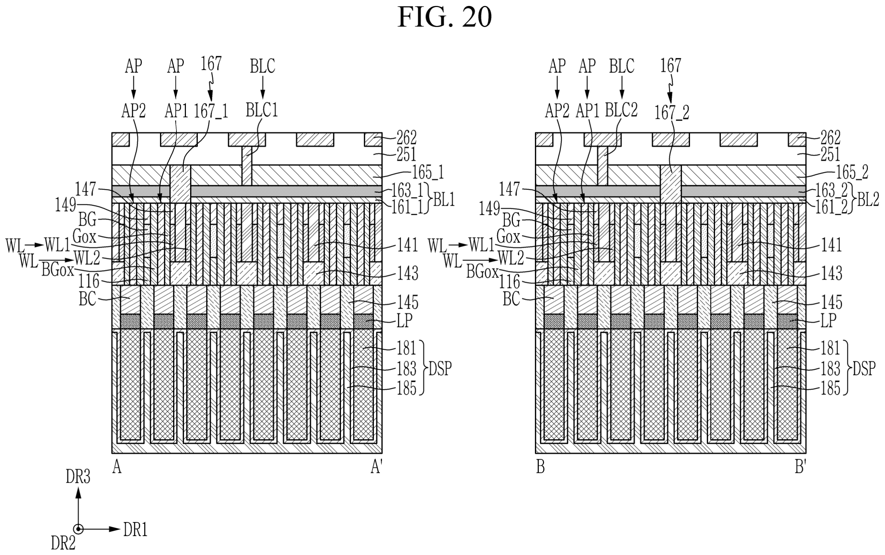

FIGS. 8 to 20 are process cross-sectional views illustrating a method of manufacturing a semiconductor device according to embodiments. FIGS. 8 to 19 each correspond to the cross-section cut along the A-A' line of FIG. 3, and FIG. 20 may correspond to cross-sections cut along the A-A' line and the B-B' line of FIG. 3.

Referring to FIG. 8, an insulating layer 110 may be formed on the cell substrate 100, and a plurality of back gate trenches WT may be formed by etching a portion of the insulating layer 110 and the cell substrate 100.

The cell substrate 100 may be a semiconductor substrate. For example, the cell substrate 100 may be a single crystal silicon substrate, however, it is not limited thereto.

First, the insulating layer 110 may be formed on the upper surface of the cell substrate 100 through a deposition process. For example, the insulating layer 110 may be formed through an ALD (atomic layer deposition) process, a PVD (physical vapor deposition) process, or a CVD (chemical vapor deposition) process, but is not limited thereto.

The insulating layer 110 may include an insulating material. For example, the insulating layer 110 may include silicon nitride, but is not limited thereto.

Subsequently, the plurality of back gate trenches WT may be formed by etching a portion of the insulating layer 110 and the cell substrate 100. The plurality of back gate trenches WT may be positioned spaced apart in a first direction DR1. The first direction DR1 may be a direction parallel to the upper surface of the cell substrate 100.

The back gate trench WT may penetrate the insulating layer 110 in a third direction DR3. The third direction DR3 may be a direction perpendicular to the upper surface of the cell substrate 100. The back gate trench WT may extend in the third direction DR3 from an upper surface toward a lower surface of the cell substrate 100. The back gate trench WT may have an embedded form in the upper surface of the cell substrate 100. The back gate trench WT may have a depth in the third direction DR3.

The back gate trench WT may extend in a second direction DR2. The second direction DR2 may be parallel to the upper surface of the cell substrate 100 and may be a direction intersecting the first direction DR1. For example, the second direction DR2 may be a direction orthogonal to the first direction DR1.

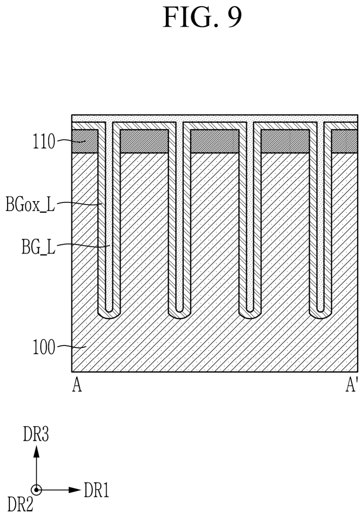

Referring to FIG. 9, a back gate insulating material layer BGox_L and a back gate electrode material layer BG_L may be sequentially formed in the plurality of back gate trenches WT. For example, the back gate insulating material layer BGox_L and the back gate electrode material layer BG_L may be formed through a deposition process. For example, the back gate insulating material layer BGox_L and the back gate electrode material layer BG_L each may be formed by an ALD process, a PVD process, or a CVD process, but are not limited thereto.

The back gate insulating material layer BGox_L may cover the inner surfaces of the plurality of back gate trenches WT with a uniform thickness. The back gate insulating material layer BGox_L may further cover the upper surface of the insulating layer 110. The back gate electrode material layer BG_L may be positioned on the back gate insulating material layer BGox_L. The back gate electrode material layer BG_L may fill the remaining space after the back gate insulating material layer BGox_L is formed in the plurality of back gate trenches WT. The back gate electrode material layer BG_L in the plurality of back gate trenches WT may be surrounded by the back gate insulating material layer BGox_L.

The back gate insulating material layer BGox_L may include silicon oxide, silicon oxynitride, a high dielectric constant material having a dielectric constant higher than that of silicon oxide, or a combination thereof. For example, the high dielectric constant material may include any one of HfO₂, HfSiO, HfSiON, HfTaO, HfTiO, HfZrO, ZrO₂, Al₂O₃, or a combination thereof, but is not limited thereto.

The back gate electrode material layer BG_L may include a conductive material. For example, the back gate electrode material layer BG_L may include doped polysilicon, metal, conductive metal nitride, conductive metal silicon nitride, conductive metal carbonitride, conductive metal silicide, conductive metal oxide, conductive two-dimensional material, or a combination thereof.

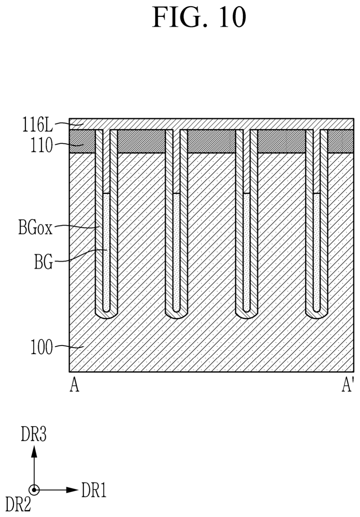

Referring to FIG. 10, portions of the back gate electrode material layer BG_L and portions of the back gate insulating material layer BGox_L are etched to form a plurality of back gate electrodes BG and a plurality of back gate insulating patterns BGox, and a first back gate capping material layer 116L may be formed on the plurality of back gate electrodes BG.

The back gate electrode material layer BG_L and the back gate insulating material layer BGox_L may, for example, be formed through an etch-back process. Portions of the back gate insulating material layer BGox_L and portions of the back gate electrode material layer BG_L covering the upper surface of the insulating layer 110 may be removed in the etching process. Portions of the back gate electrode material layer BG_L positioned on the upper part of the plurality of back gate trenches WT may be removed in the etching process. Accordingly, the upper surface of the back gate electrode BG may have a lower height than the upper surface of the back gate insulating pattern BGox. Side surfaces of the plurality of back gate insulating patterns BGox positioned on an upper portion of the plurality of back gate trenches WT may be exposed.

Subsequently, the first back gate capping material layer 116L may be formed on the plurality of back gate electrodes BG. The first back gate capping material layer 116L may be formed through a deposition process. For example, the first back gate capping material layer 116L may be formed through an ALD process, a PVD process, or a CVD process, but is not limited thereto.

The first back gate capping material layer 116L may cover the upper surfaces of the plurality of back gate electrodes BG, and side surfaces of the plurality of back gate insulating patterns BGox positioned in the upper portion of the plurality of back gate trenches WT. The first back gate capping material layer 116L may further cover the upper surface of the insulating layer 110.

The first back gate capping material layer 116L may include an insulating material. The first back gate capping material layer 116L may include a material having an etching selectivity with respect to the insulating layer 110. For example, the insulating layer 110 may include silicon nitride, and the first back gate capping material layer 116L may include silicon oxide, but is not limited thereto.

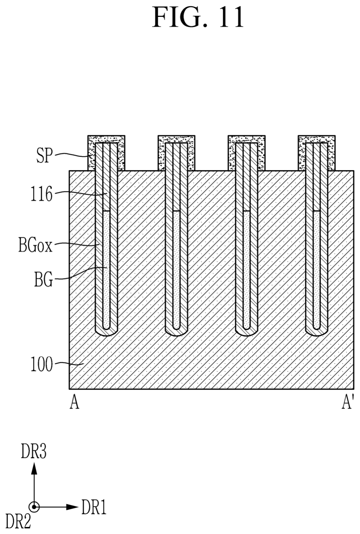

Referring to FIG. 11, a portion of the first back gate capping material layer 116L is etched to form a plurality of first back gate capping patterns 116 on the plurality of back gate electrodes BG, the insulating layer 110 is removed, and a plurality of spacers SP surrounding the upper portions of the plurality of back gate insulating patterns BGox and the upper portions of the plurality of first back gate capping patterns 116 may be formed.

First, a portion of the first back gate capping material layer 116L may be etched to form the plurality of first back gate capping patterns 116. The etching process may proceed until an upper surface of the insulating layer 110 is exposed. The insulating layer 110 may serve as an etching stop layer. The upper surface of the plurality of first back gate capping patterns 116 may be positioned at the same level as the upper surface of the insulating layer 110 and the upper surfaces of the plurality of back gate insulating patterns BGox.

Subsequently, the insulating layer 110 may be removed. For example, the insulating layer 110 may be removed through a selective etching process. As the insulating layer 110 is removed, side surfaces of upper portions of the plurality of back gate insulating patterns BGox may be exposed. As the insulating layer 110 is removed, the upper surface of the cell substrate 100 may be exposed.

Subsequently, the plurality of spacers SP surrounding the upper portions of the plurality of back gate insulating patterns BGox and the upper portions of the plurality of first back gate capping patterns 116 may be formed. For example, after forming a spacer material layer covering the upper surfaces of the plurality of back gate insulating patterns BGox, the upper surfaces of the plurality of first back gate capping patterns 116, and the upper surface of the cell substrate 100, the spacer material layer may be patterned to form the plurality of spacers SP. Each of the plurality of spacers SP may surround the upper portion of the back gate insulating pattern BGox and the upper portion of the first back gate capping pattern 116. The spacer SP may be positioned on the upper surface of the back gate insulating pattern BGox and on the upper surface of the first back gate capping pattern 116. The spacer SP may be positioned on the side surface of an upper portion of the back gate insulating pattern BGox. The spacer SP may cover the upper surface of the cell substrate 100 adjacent to the back gate insulating pattern BGox.

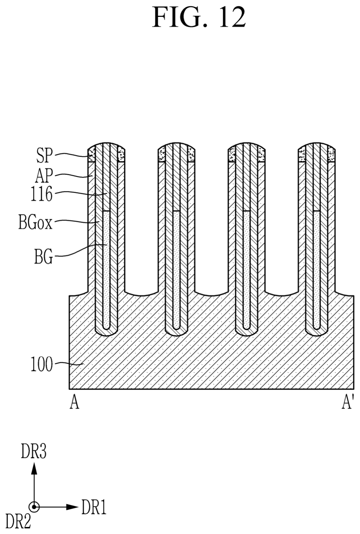

Referring to FIG. 12, the plurality of spacers SP may be used as etching masks to etch a portion of the cell substrate 100 to form a plurality of active patterns AP.

An upper surface of the cell substrate 100 that is not covered by the plurality of spacers SP may be etched in the etching process. A portion of the cell substrate 100 positioned between the plurality of back gate insulating patterns BGox spaced apart in the first direction DR1 may be removed. An upper surface of the cell substrate 100 adjacent to the plurality of back gate insulating patterns BGox is covered by the plurality of spacers SP, so a portion of the cell substrate 100 positioned on the side surfaces of the plurality of back gate insulating patterns BGox may remain without being removed. Portions of the cell substrate 100 positioned on the side surfaces of the plurality of back gate insulating patterns BGox may respectively constitute the plurality of active patterns AP. Each of the plurality of active patterns AP may have a shape extended in the third direction DR3 along the side surface of each of the plurality of back gate insulating patterns BGox from an upper surface of the cell substrate 100. The plurality of active patterns AP may be spaced apart and may be arranged in the first direction DR1 and the second direction DR2.

Portions of the plurality of spacers SP, which were covering the upper surfaces of the plurality of back gate insulating patterns BGox and the upper surfaces of the plurality of first back gate capping patterns 116, may be removed together during the etching process. Accordingly, the upper surfaces of the plurality of back gate insulating patterns BGox and the upper surfaces of the plurality of first back gate capping patterns 116 may be exposed. However, embodiments are not limited thereto. For example, portions of the plurality of spacers SP covering the upper surfaces of the plurality of back gate insulating patterns BGox and the upper surfaces of the plurality of first back gate capping patterns 116 may not be removed. In this case, the upper surfaces of the plurality of back gate insulating patterns BGox and the upper surfaces of the plurality of first back gate capping patterns 116 may not be exposed.

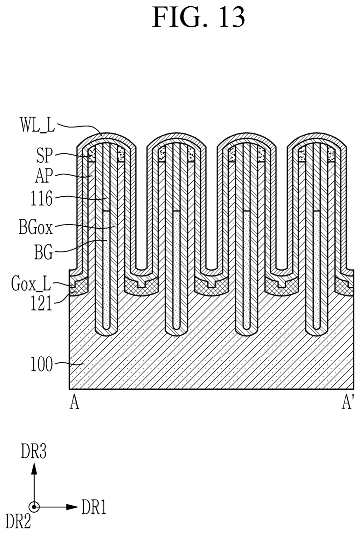

Referring to FIG. 13, a gate insulating material layer Gox_L and a gate electrode material layer WL_L may be sequentially formed on the plurality of active patterns AP.

First, a plurality of insulating patterns 121 covering the upper surface of the cell substrate 100 and side surfaces of lower portions of the plurality of active patterns AP may be formed, but is not limited thereto.

Subsequently, the gate insulating material layer Gox_L covering side surfaces of the plurality of active patterns AP may be formed through a deposition process. For example, the gate insulating material layer Gox_L may be formed by an ALD process, a PVD process, or a CVD process, but is not limited thereto.

The gate insulating material layer Gox_L may cover side surfaces of the plurality of active patterns AP with a uniform thickness. The gate insulating material layer Gox_L may cover upper surfaces of the plurality of insulating patterns 121. For example, when the plurality of insulating patterns 121 are omitted, the gate insulating material layer Gox_L may cover an upper surface of the cell substrate 100. The gate insulating material layer Gox_L may cover the side surfaces and upper surfaces of the plurality of spacers SP. The gate insulating material layer Gox_L may cover the upper surfaces of the plurality of back gate insulating patterns BGox and the upper surfaces of the plurality of first back gate capping patterns 116.

The gate insulating material layer Gox_L may include silicon oxide, silicon oxynitride, a high dielectric constant material having a dielectric constant higher than that of silicon oxide, or a combination thereof. For example, a high dielectric constant material may include any one of HfO₂, HfSiO, HfSiON, HfTaO, HfTiO, HfZrO, ZrO₂, Al₂O₃, or a combination thereof, but is not limited thereto.

The gate insulating material layer Gox_L and the back gate insulating pattern BGox may include the same material. In this case, the interface between the gate insulating material layer Gox_L and the back gate insulating pattern BGox may not be visually recognized. However, the embodiments are not limited thereto. For example, the gate insulating material layer Gox_L and the back gate insulating pattern BGox may include different materials.

Subsequently, through a deposition process, the gate electrode material layer WL_L may be formed on the gate insulating material layer Gox_L. For example, the gate electrode material layer WL_L may be formed by an ALD process, a PVD process, or a CVD process, but is not limited thereto. The gate electrode material layer WL_L may cover the surface of the gate insulating material layer Gox_L with a uniform thickness.

The gate electrode material layer WL_L may include a conductive material. For example, the gate electrode material layer WL_L may include doped polysilicon, metal, conductive metal nitride, conductive metal silicon nitride, conductive metal carbonitride, conductive metal silicide, conductive metal oxide, conductive two-dimensional material, or a combination thereof.

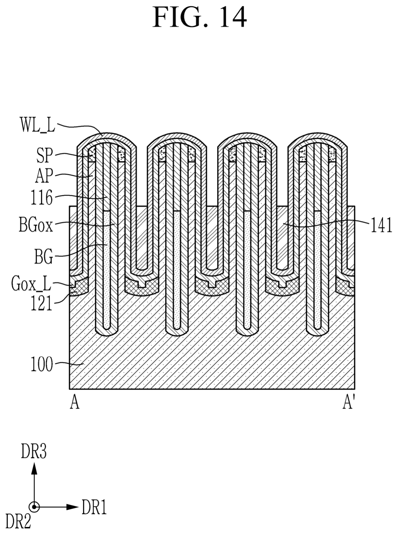

Referring to FIG. 14, a plurality of gate separation patterns 141 may be formed on the gate electrode material layer WL_L.

For example, a gate separation material layer may be formed on the gate electrode material layer WL_L through a deposition process. The gate separation material layer may fill a space surrounded by a gate electrode material layer WL_L positioned on the plurality of active patterns AP spaced apart in the first direction DR1. The gate separation material layer may be formed to cover a portion of the gate electrode material layer WL_L positioned on the upper surfaces of the plurality of spacers SP, the plurality of back gate insulating patterns BGox, and the plurality of first back gate capping patterns 116.

The gate separation material layer may include an insulating material. For example, the gate separation material layer may include silicon nitride, but is not limited thereto.

Subsequently, an etch-back process is performed to remove portions of the plurality of spacers SP, the plurality of back gate insulating patterns BGox, and the plurality of first back gate capping patterns 116, thereby forming the plurality of gate separation patterns 141. Portions of the gate separation material layer positioned on the plurality of spacers SP, the plurality of back gate insulating patterns BGox, and the plurality of first back gate capping patterns 116 may be removed in the etching process. Also, portions of the gate separation material layer positioned on the side surfaces of the upper portions of the plurality of active patterns AP may be removed during the etching process.

The plurality of gate separation patterns 141 may be surrounded by the gate electrode material layer WL_L between the plurality of active patterns AP spaced apart in the first direction DR1. Both side surfaces and a lower surface of the plurality of gate separation patterns 141 may be surrounded by the gate electrode material layer WL_L. An upper surface of the plurality of gate separation patterns 141 may be positioned at a lower level than an upper surface of the active pattern AP.

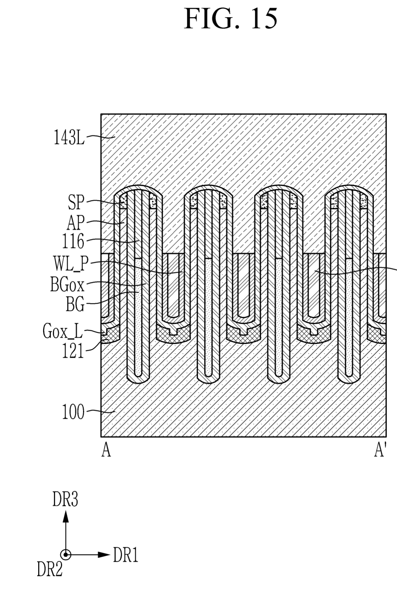

Referring to FIG. 15, a portion of the gate electrode material layer WL_L is removed to form a plurality of preliminary word lines WL_P, and a first gate capping material layer 143L may be formed on the plurality of gate separation patterns 141 and the plurality of preliminary word lines WL_P.

First, portions of the gate electrode material layer WL_L that are not covered by the plurality of gate separation patterns 141 may be removed through an etching process. Portions of the gate electrode material layer WL_L positioned on the plurality of spacers SP, the plurality of back gate insulating patterns BGox, and the plurality of first back gate capping patterns 116 may be removed. In addition, portions of the gate electrode material layer WL_L positioned on the side surfaces of the upper portions of the plurality of active patterns AP may be removed. Accordingly, the plurality of preliminary word lines WL_P may be formed between the plurality of active patterns AP spaced apart in the first direction DR1. The plurality of active patterns AP spaced apart in the first direction DR1 may be positioned between the plurality of back gate electrodes BG spaced apart in the first direction DR1.

For example, in the process of etching the gate electrode material layer WL_L, a portion of the gate insulating material layer Gox_L may be removed together. The thickness of the gate insulating material layer Gox_L, which is positioned on the upper surfaces of the plurality of spacers SP, the plurality of back gate insulating patterns BGox, and the plurality of first back gate capping patterns 116, may be reduced. However, embodiments are not limited thereto, and in the process of etching the gate electrode material layer WL_L, the gate insulating material layer Gox_L may not be etched.

Subsequently, through a deposition process, the first gate capping material layer 143L may be formed on the plurality of gate separation patterns 141 and on the plurality of preliminary word lines WL_P. For example, the first gate capping material layer 143L may be formed by an ALD process, a PVD process, or a CVD process, but is not limited thereto.

The first gate capping material layer 143L may cover the upper surfaces of the plurality of gate separation patterns 141 and the upper surfaces of the plurality of preliminary word lines WL_P. The first gate capping material layer 143L may cover the upper surface and side surface of the gate insulating material layer Gox_L exposed as a result of partial removal of the gate electrode material layer WL_L. The first gate capping material layer 143L may be positioned on side surfaces of a plurality of active patterns AP.

The first gate capping material layer 143L may include an insulating material. For example, the first gate capping material layer 143L may include silicon nitride, but is not limited thereto.

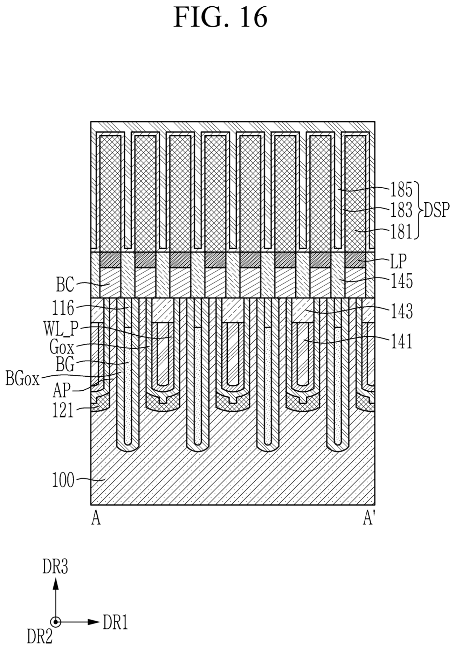

Referring to FIG. 16, a portion of the first gate capping material layer 143L and a portion of the gate insulating material layer Gox_L are removed to form a plurality of first gate capping patterns 143 and a plurality of gate insulating patterns Gox.

For example, a portion of the first gate capping material layer 143L and a portion of the gate insulating material layer Gox_L may be removed through a planarization process. In the planarization process, portions of the plurality of first back gate insulating patterns BGox, portions of the plurality of first back gate capping patterns 116, and portions of the plurality of active patterns AP may be removed together. In the planarization process, the plurality of spacers SP may be completely removed.

The upper surfaces of the plurality of first gate capping patterns 143, the upper surfaces of the plurality of gate insulating patterns Gox, the upper surfaces of the plurality of first back gate insulating patterns BGox, the upper surfacse of the plurality of first back gate capping patterns 116, and the upper surfaces of the plurality of active patterns AP may be positioned at the same level.

For example, the planarization process may include a CMP (chemical mechanical polishing) process.

Subsequently, a plurality of storage contacts BC, a plurality of landing pads LP, and a plurality of capacitors DSP may be sequentially formed on the plurality of active patterns AP.

For example, a contact separation insulating layer 145 may be formed, and the contact separation insulating layer 145 may be patterned to expose upper surfaces of the plurality of active patterns AP. Subsequently, the plurality of storage contacts BC, the plurality of landing pads LP, and the plurality of capacitors DSP may be sequentially formed on the upper surface of the exposed plurality of active patterns AP.

The plurality of storage contacts BC may be arranged spaced apart along the first direction DR1 and the second direction DR2. Each of the plurality of storage contacts BC may overlap the active pattern AP in the third direction DR3. Each of the plurality of storage contacts BC may overlap, in the third direction DR3, the back gate insulating pattern BGox and gate insulating pattern Gox respectively positioned on both sides of the active pattern AP. Each of the plurality of storage contacts BC may overlap the first gate capping pattern 143 in the third direction DR3.

The planar shape of the storage contact BC may be circular, but is not limited thereto. For example, the storage contact BC may have various planar shapes, such as an oval, a rectangle, a square, a rhombus, or a hexagon.

The plurality of landing pads LP may be arranged spaced apart along the first direction DR1 and the second direction DR2. The plurality of landing pads LP may be arranged in a matrix shape. Each of the plurality of landing pads LP may be overlapped with the storage contact BC in the third direction DR3.

The planar shape of the landing pad LP may be circular, but is not limited thereto. For example, the landing pad LP may have various planar shapes such as an oval, a rectangle, a square, a rhombus, or a hexagon.

The contact separation insulating layer 145 may be positioned between the plurality of storage contacts BC and between the plurality of landing pads LP. The contact separation insulating layer 145 may surround side surfaces of the plurality of storage contacts BC. The contact separation insulating layer 145 may surround side surfaces of the plurality of landing pads LP. The contact separation insulating layer 145 is shown as a single layer; however, it is not limited thereto and may be formed as a multilayer. For example, the contact separation insulating layer 145 may include an insulating layer surrounding side surfaces of the plurality of storage contacts BC and an insulating layer surrounding side surfaces of the plurality of landing pads LP. The two insulating layers may include the same material, or may include different materials.

The contact separation insulating layer 145 may include an insulating material. For example, the contact separation insulating layer 145 may include silicon nitride, but is not limited thereto.

The storage contact BC may include a conductive material. For example, the storage contact BC may include doped polysilicon, metal, conductive metal nitride, conductive metal silicon nitride, conductive metal carbonitride, conductive metal silicide, conductive metal oxide, conductive two-dimensional material, or a combination thereof.

The landing pad LP may include a conductive material. For example, the storage contact BC may include doped polysilicon, metal, conductive metal nitride, conductive metal silicon nitride, conductive metal carbonitride, conductive metal silicide, conductive metal oxide, conductive two-dimensional material, or a combination thereof.

A plurality of capacitors DSP may be positioned on the plurality of landing pads LP, respectively. The plurality of capacitors DSP may be arranged spaced apart along the first direction DR1 and the second direction DR2. The plurality of capacitors DSP may be arranged in a matrix pattern.

The capacitor DSP may be overlapped with the landing pad LP in the third direction DR3. The capacitor DSP may be connected to the active pattern AP via the landing pad LP and the storage contact BC. The capacitor DSP may be connected to the storage contact BC through the landing pad LP. However, embodiments are not limited thereto. For example, the landing pad LP may be omitted. In this case, the capacitor DSP may be directly connected to the storage contact BC.

The capacitor DSP may include a first electrode 181, a second electrode 185, and a dielectric layer 183 positioned between the first electrode 181 and the second electrode 185. The first electrode 181 may be connected to the landing pad LP. The first electrode 181 may extend in the third direction DR3 over the landing pad LP. The dielectric layer 183 may extend along the profile of the lower surface and side surface of the first electrode 181. The dielectric layer 183 may cover the lower surface and side surface of the first electrode 181 with a uniform thickness. The dielectric layer 183 may also be positioned on the upper surface of the contact separation insulating layer 145. The second electrode 185 may be positioned on the dielectric layer 183. The second electrode 185 may cover the upper surface and side surfaces of the first electrode 181. A plurality of first electrodes 181 of the plurality of capacitors DSP may be spaced apart from each other. The dielectric layer 183 and the second electrode 185 of the plurality of capacitors DSP may be integrally connected.

The first electrode 181 and the second electrode 185 may include a conductive material. The first electrode 181 may include a metal, a conductive metal nitride, or a combination thereof. For example, the first electrode 181 may include TiN, Ru, TaN, WN, Pt, Ir, or a combination thereof. The second electrode 185 may include metal, conductive metal nitride, metal silicide, or a combination thereof. For example, the second electrode 185 may include W, Ti, Ru, or SiGe. However, the materials included in the first electrode 181 and the second electrode 185 are not limited thereto, and may be variously changed.

The dielectric layer 183 may include tantalum oxide (Ta₂O₅), aluminum oxide (Al₂O₃), titanium oxide (TiO₂), or a combination thereof. However, the material included in the dielectric layer 183 is not limited thereto and may be variously modified.

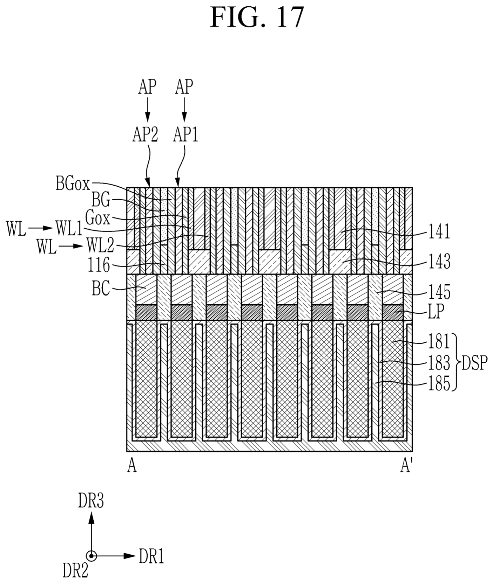

Referring to FIG. 17, after flipping the cell substrate 100, a wafer thinning process may be performed to remove the cell substrate 100. The wafer thinning process may include, for example, a grinding process.

Portions of the plurality of back gate insulating patterns BGox and portions of the plurality of back gate electrodes BG may be removed together with the cell substrate 100. Also, portions of the plurality of active patterns AP may be removed. In addition, portions of the plurality of gate insulating patterns Gox, portions of the plurality of preliminary word lines WL_P, and portions of the plurality of gate separation patterns 141 may be removed. In addition, the plurality of insulating patterns 121 may be completely removed.

The plurality of active patterns AP, which had been connected by the cell substrate 100, may be separated as the cell substrate 100 is removed. The plurality of active patterns AP may include a first active pattern AP1 and a second active pattern AP2 respectively positioned on both sides of the back gate electrode BG.

As portions of the plurality of back gate insulating patterns BGox is removed, each of the plurality of back gate insulating patterns BGox may be separated into a portion positioned between the first active pattern AP1 and the back gate electrode BG, and a portion positioned between the second active pattern AP2 and the back gate electrode BG.

The back gate electrode BG may extend in the second direction DR2. The back gate electrode BG may overlap in the first direction DR1 with the plurality of active patterns AP spaced apart along the second direction DR2. The back gate insulating pattern BGox may be positioned between the back gate electrode BG and the active pattern AP.

As portions of the plurality of gate insulating patterns Gox is removed, each of the plurality of gate insulating patterns Gox may be separated into a portion positioned between the first word line WL1 and the first active pattern AP1, and a portion positioned between the second word line WL2 and the second active pattern AP2.

As portions of the plurality of preliminary word lines WL_P is removed, a plurality of word lines WL may be formed. A pair of word lines WL1, WL2 may be formed by removing a portion of each preliminary word line WL_P. The pair of word lines WL1, WL2 may include a first word line WL1 and a second word line WL2 spaced apart in the first direction DR1.

The pair of word lines WL1, WL2 may be positioned between the plurality of active patterns AP that are spaced apart in the first direction DR1. The pair of word lines WL1, WL2 may be positioned between the plurality of back gate electrodes BG spaced apart in the first direction DR1. The gate separation pattern 141 may be positioned between the pair of word lines WL1, WL2.

The word line WL may extend in the second direction DR2. The word line WL may overlap in the first direction DR1 with the plurality of active patterns AP spaced apart along the second direction DR2. The gate insulating pattern Gox may be positioned between the word line WL and the active pattern AP.

Upper surfaces of the plurality of back gate electrodes BG, upper surfaces of the plurality of word lines WL, upper surfaces of the plurality of active patterns AP, upper surfaces of the plurality of back gate insulating patterns BGox, upper surfaces of the plurality of gate insulating patterns Gox, and upper surfaces of the plurality of gate separation patterns 141 may be positioned at substantially the same level.

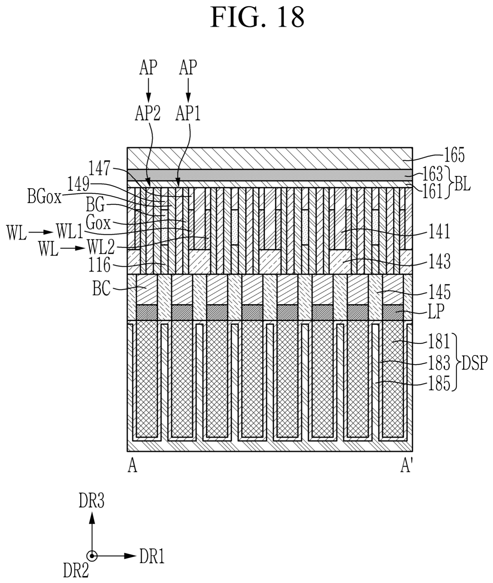

Referring to FIG. 18, after removing portions of the plurality of word lines WL and portions of the plurality of back gate electrodes BG, a plurality of second gate capping patterns 147 may be formed on the plurality of word lines WL, and a plurality of second back gate capping patterns 149 may be formed on the plurality of back gate electrodes BG.

For example, through an etching process, portions of the plurality of word lines WL and portions of the plurality of back gate electrodes BG may be removed. For example, after forming a photoresist pattern exposing upper surfaces of the plurality of word lines WL and the plurality of gate electrodes BG, the etching process may be performed. In another example, a material having a high etching selectivity for the material of the word line WL and the material of the back gate electrode BG may be used to selectively remove the plurality of word lines WL and the plurality of back gate electrodes BG.

The upper surfaces of the plurality of word lines WL and the upper surfaces of the plurality of back gate electrodes BG may be positioned at a lower level than the upper surfaces of the plurality of active patterns AP. The plurality of word lines WL and the plurality of back gate electrodes BG may overlap in the first direction DR1 with the center portions of the plurality of active patterns AP extending in the third direction DR3. As a voltage equal to or greater than the threshold voltage is applied to the word line WL, a channel may be formed in the region of the active pattern AP overlapping the word line WL.

Subsequently, the plurality of second gate capping patterns 147 may be formed on the plurality of word lines WL, and the plurality of second back gate capping patterns 149 may be formed on the plurality of back gate electrodes BG. For example, a capping material layer may be formed on the plurality of word lines WL and the plurality of back gate electrodes BG through a deposition process. The capping material layer may be formed to cover the upper surfaces of the plurality of active patterns AP, the upper surfaces of the plurality of gate insulating patterns Gox, the upper surfaces of the plurality of back gate insulating patterns BGox, and the upper surfaces of the plurality of gate separation patterns 141. Thereafter, portions of the capping material layer positioned on the upper surfaces of the plurality of active patterns AP, the upper surfaces of the plurality of gate insulating patterns Gox, the upper surfaces of the plurality of back gate insulating patterns BGox, and the upper surfaces of the plurality of gate separation patterns 141 may be removed to form the plurality of second gate capping patterns 147 and the plurality of second back gate capping patterns 149. The upper surfacse of the plurality of second gate capping patterns 147 and the upper surfaces of the plurality of second back gate capping patterns 149 may be positioned at substantially the same level as the upper surfaces of the plurality of active patterns AP, the upper surfaces of the plurality of gate insulating patterns Gox, the upper surfaces of the plurality of back gate insulating patterns BGox, and the upper surfaces of the plurality of gate separation patterns 141.

The second gate capping pattern 147 and the second back gate capping pattern 149 may include an insulating material. For example, the second gate capping pattern 147 and the second back gate capping pattern 149 may include silicon nitride, but are not limited thereto. The second gate capping pattern 147 and the second back gate capping pattern 149 may include the same material, but are not limited thereto. The second gate capping pattern 147 and the second back gate capping pattern 149 may include different materials.

Subsequently, a bit line BL and a bit line capping layer 165 may be sequentially formed on the plurality of active patterns AP spaced apart and arranged in the first direction DR1.

For example, a first material layer, a second material layer, and a third material layer may be sequentially formed on the plurality of active patterns AP through a deposition process. The first material layer, the second material layer, and the third material layer may be formed by, for example, an ALD process, a PVD process, or a CVD process, but are not limited thereto.

For example, the first material layer may include polysilicon. For example, the second material layer may include a metal. The third material layer may include an insulating material. For example, the third material layer may include silicon nitride, however, it is not limited thereto.

Subsequently, the first material layer, the second material layer, and the third material layer may be patterned to form a plurality of bit lines BL and a plurality of bit line capping layers 165 positioned on the plurality of bit lines BL. For example, a photoresist pattern may be formed on the third material layer, and by using the photoresist pattern, a portion of the first material layer, a portion of the second material layer, and a portion of the third material layer may be etched to form the plurality of bit lines BL and the plurality of bit line capping layers 165.

Each of the plurality of bit lines BL (BL1, BL2) may include a polysilicon layer 161 (161_1, 161_2) and a metal layer 163 (163_1, 163_2) positioned on the polysilicon layer 161. The polysilicon layer 161 may be a portion of the first material layer. The metal layer 163 may be a portion of the second material layer. Each of the plurality of bit line capping layers 165 may be positioned on the metal layer 163. The bit line capping layer 165 may be a portion of the third material layer.

The bit line BL may extend in the first direction DR1. The bit line BL may be connected to the plurality of active patterns AP spaced apart and arranged in the first direction DR1. The plurality of bit lines BL may be spaced apart and may be arranged in the second direction DR2. The plurality of bit lines BL spaced apart and arranged in the second direction DR2 may each be connected to the plurality of active patterns AP spaced apart and arranged in the second direction DR2.

In the above-described embodiment, it has been described that the bit line BL and the bit line capping layer 165 are formed through a deposition process and a patterning process of material layers corresponding to the bit line BL and the bit line capping layer 165, but the present invention is not limited thereto. The process of forming the bit line BL and the bit line capping layer 165 may be variously modified.

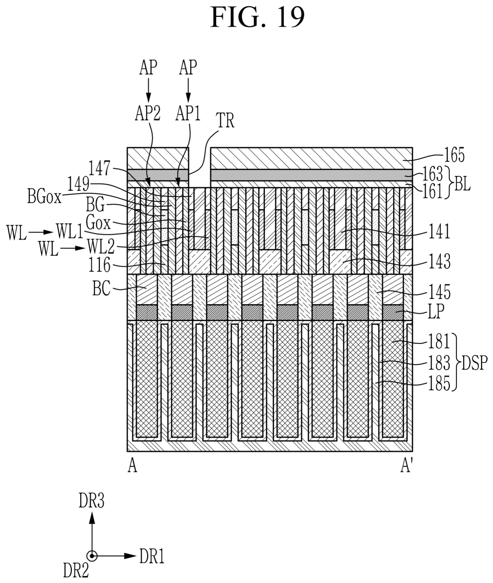

Referring to FIG. 19, a plurality of insulating trenches TR may be formed by etching portions of the plurality of bit lines BL and portions of the plurality of bit line capping layers 165.

For example, a photoresist pattern may be formed on the plurality of bit line capping layers 165, and using the photoresist pattern, portions of the plurality of bit line capping layers 165 and portions of the plurality of bit lines BL may be etched to form the plurality of insulating trenches TR penetrating the bit line capping layers 165 and the bit lines BL in the third direction DR3.

In the cross-sectional view shown in FIG. 19, one insulating trench TR is illustrated, however, the plurality of insulating trenches TR may be formed. The plurality of insulating trenches TR may be arranged spaced apart along the first direction DR1. The plurality of bit lines BL may be spaced apart in the first direction DR1 by the plurality of insulating trenches TR. In addition, the plurality of insulating trenches TR may be arranged spaced apart along the second direction DR2.

The plurality of insulating trenches TR may be arranged spaced apart at regular intervals in the first direction DR1. According to the interval at which the plurality of insulating trenches TR are spaced apart in the first direction DR1, among the plurality of bit lines BL spaced apart in the first direction DR1 by the plurality of insulating trenches TR, the bit line BL positioned at an end may have a length in the first direction DR1 that is shorter than that of other bit lines BL. In this case, as shown in FIG. 7, a short bit line SBL positioned at the end in the first direction DR1 and having a length shorter than the bit line BL may be formed. A plurality of short bit lines SBL may be arranged spaced apart along the second direction DR2 at an edge of the cell array region CAR in the first direction DR1. The plurality of short bit lines SBL may each be connected in pairs adjacent in the second direction DR2 by a connection wiring 262C and may be controlled as a single bit line BL.

For example, the insulating trench TR may overlap with the pair of word lines WL1, WL2 in the third direction DR3. The insulating trench TR may be overlapped in the third direction DR3 with the gate separation pattern 141 positioned between the pair of word lines WL1, WL2. The insulating trench TR may not overlap with the active pattern AP in the third direction DR3. However, the embodiments are not limited thereto, and the position and overlap relationship of the insulating trench TR may be variously modified.

FIG. 20 may correspond to the cross-sections taken along the A-A' line and the B-B' line of FIG. 3. The A-A' cross-section and the B-B' cross-section of FIG. 20 may be cross-sections overlapping in the second direction DR2.

Referring to FIG. 20, a plurality of bit line insulating patterns 167 may be formed in the plurality of insulating trenches TR.

For example, an insulating material layer filling the inside of the plurality of insulating trenches TR may be formed through a deposition process. The insulating material layer may be formed to cover upper surfaces of the plurality of bit line capping layers 165, but a portion of the insulating material layer covering the upper surfaces of the plurality of bit line capping layers 165 may be removed. Accordingly, the plurality of bit line insulating patterns 167 may be formed in the plurality of insulating trenches TR.

The plurality of bit line insulating patterns 167 may be arranged alternately and repeatedly with the plurality of bit lines BL along the first direction DR1. The plurality of bit line insulating patterns 167 may include the bit line insulating pattern 167 positioned between two bit lines BL adjacent in the first direction DR1. The plurality of bit line insulating patterns 167 may be arranged alternately and repeatedly with the plurality of bit lines BL along the second direction DR2. The bit line insulating pattern 167 may overlap the bit line BL in the second direction DR2.

Subsequently, a cell insulating layer 251 may be formed on the plurality of bit line capping layers 165. For example, the cell insulating layer 251 covering the upper surfaces of the plurality of bit line capping layers 165 may be formed through a deposition process.

Subsequently, a plurality of bit line contacts BLC may be formed on the plurality of bit lines BL, and a first cell wiring layer 262 may be formed on the plurality of bit line contacts BLC. For example, a photoresist pattern may be formed on the cell insulating layer 251, and using the photoresist pattern, a portion of the cell insulating layer 251 and portions of the plurality of bit line capping layers 165 may be etched to form a plurality of contact holes. The contact hole may penetrate the cell insulating layer 251 and the bit line capping layer 165 in the third direction DR3. For example, the plurality of bit line contacts BLC may be formed in the plurality of contact holes through a deposition process. In addition, the first cell wiring layer 262 may be formed on the plurality of bit line contacts BLC.

The bit line contact BLC may connect the first cell wiring layer 262 and the bit line BL. The wiring of the first cell wiring layer 262 connected to the bit line BL by the bit line contact BLC may extend in the second direction DR2 intersecting the bit line BL.

A portion of the bit line BL to which the bit line contact BLC is connected may overlap the bit line insulating pattern 167 in the second direction DR2. For example, the plurality of bit lines BL may include a plurality of first bit lines BL1 and a plurality of second bit lines BL2 adjacent in the second direction DR2. The plurality of first bit lines BL1 may be spaced apart and may be arranged in the first direction DR1. The plurality of second bit lines BL2 may be spaced apart and may be arranged in the first direction DR1. A bit line insulating pattern 167_1 positioned between the plurality of first bit lines BL1 spaced apart in the first direction DR1 may overlap with the second bit line BL2 in the second direction DR2. The second bit line BL2 overlapping with the first bit line insulating pattern 167_1 in the second direction DR2 may be a portion to which the second bit line contact BLC2 is connected. A second bit line insulating pattern 167_2 positioned between the plurality of second bit lines BL2 spaced apart in the first direction DR1 may overlap the first bit line BL1 in the second direction DR2. The first bit line BL1 overlapping with the second bit line insulating pattern 167_2 and the second direction DR2 may be a portion where the first bit line contact BLC1 is connected.

A cell structure including a plurality of memory cells may be formed according to the above-described embodiment. In a subsequent process, a peripheral circuit and a circuit wiring layer may be formed on a peripheral circuit substrate to form a peripheral circuit structure, and the cell structure and the peripheral circuit structure may be bonded by stacking in the third direction DR3. For example, the peripheral circuit structure may be laminated on the cell structure, but is not limited thereto. As another example, the cell structure may be laminated on the peripheral circuit structure.

A method of manufacturing a semiconductor device according to embodiments includes forming a plurality of back gate trenches in a cell substrate, sequentially forming a back gate insulating pattern, a back gate electrode, and a first back gate capping pattern in each of the back gate trenches, etching portions of the cell substrate positioned on both sides of the back gate insulating pattern in a first direction to form a plurality of active patterns spaced apart and arranged in the first direction and in a second direction intersecting the first direction, forming a plurality of gate insulating patterns and a plurality of preliminary word lines on side surfaces of the plurality of active patterns in the first direction, forming a plurality of gate separation patterns on the plurality of preliminary word lines, forming a plurality of first gate capping patterns on the plurality of preliminary word lines and the plurality of gate separation patterns, sequentially forming a plurality of storage contacts and a plurality of capacitors on upper surfaces of the plurality of active patterns, flipping the cell substrate, performing a wafer thinning process to remove the cell substrate, separating each of the plurality of preliminary word lines in the first direction to form a plurality of word lines, etching portions of the plurality of back gate electrodes and portions of the plurality of word lines, forming a plurality of second back gate capping patterns and a plurality of second gate capping patterns respectively positioned on the plurality of back gate electrodes and the plurality of word lines, forming a plurality of bit lines extending in the first direction and a plurality of bit line capping layers on the plurality of active patterns, etching portions of the plurality of bit lines and portions of the plurality of bit line capping layers to form a plurality of insulating trenches, forming a plurality of bit line insulating patterns in the plurality of insulating trenches, forming a cell insulating layer on the plurality of bit line capping layers, etching portions of the cell insulating layer and portions of the plurality of bit line capping layers to form a plurality of bit line contacts on the plurality of bit lines, and forming a cell wiring layer on the plurality of bit line contacts. The bit line insulating pattern overlaps the bit line in the second direction, and the portion of the bit line overlapping the bit line insulating pattern in the second direction is the portion where the bit line contact is connected.

The plurality of bit lines may include a plurality of first bit lines and a plurality of second bit lines adjacent in the second direction, and the plurality of first bit lines may be arranged spaced apart along the first direction, and the plurality of second bit lines may be arranged spaced apart along the first direction. The plurality of first bit lines and the plurality of second bit lines may be disposed to be staggered along the second direction.

The plurality of bit line insulating patterns may include a plurality of first bit line insulating patterns arranged alternately and repeatedly with the plurality of first bit lines along the first direction, and a plurality of second bit line insulating patterns arranged alternately and repeatedly with the plurality of second bit lines along the first direction. The plurality of first bit line insulating patterns may overlap the plurality of second bit lines in the second direction, and the plurality of second bit line insulating patterns may overlap the plurality of first bit lines in the second direction.

The plurality of bit line contacts may include a plurality of first bit line contacts connected to the plurality of first bit lines and a plurality of second bit line contacts connected to the plurality of second bit lines. The plurality of first bit line insulating patterns may overlap, in the second direction, portions of the plurality of second bit lines to which the plurality of second bit line contacts are connected. The plurality of second bit line insulating patterns may overlap, in the second direction, portions of the plurality of first bit lines, to which the plurality of first bit line contacts are connected.

The plurality of first bit line contacts may be connected to one end portions of the plurality of first bit lines in the first direction, and the plurality of second bit line contacts may be connected to the other end portions of the plurality of second bit lines in the first direction.

The plurality of first bit line contacts may be connected to central portions of the plurality of first bit lines, and the plurality of second bit line contacts may be connected to central portions of the plurality of second bit lines.

Embodiments are set out in the following clauses:
Clause 1. A semiconductor device comprising: a bit line extending in a first direction, a word line on a lower surface of the bit line and extending in a second direction intersecting the first direction, an active pattern extending from the lower surface of the bit line in a third direction substantially perpendicular to the first direction and the second direction, and overlapping the word line in the first direction, a capacitor on a lower surface of the active pattern, a cell wiring layer on an upper surface of the bit line, a bit line contact connecting the cell wiring layer and the bit line, and a bit line insulating pattern between two bit lines adjacent in the first direction among a plurality of bit lines including the bit line, wherein the bit line insulating pattern overlaps, in the second direction, another bit line different from the two bit lines.
Clause 2. The semiconductor device of Clause 1, wherein the bit line contact overlaps the capacitor in the third direction.
Clause 3. The semiconductor device of Clause 2, wherein a portion of the bit line to which the bit line contact is connected overlaps the bit line insulating pattern in the second direction.
Clause 4. The semiconductor device of Clause 3, wherein: the plurality of bit lines are spaced apart and arranged in the first direction and the second direction, and a plurality of bit line contacts including the bit line contact are respectively connected to the plurality of bit lines, the plurality of bit lines include a first bit line and a second bit line adjacent in the second direction, the plurality of bit line contacts include a first bit line contact connected to the first bit line and a second bit line contact connected to the second bit line, the first bit line contact is connected to one end portion of the first bit line in the first direction, and the second bit line contact is connected to another end portion of the second bit line in the first direction.
Clause 5. The semiconductor device of Clause 3 or 4, wherein the bit line contact is connected to a central portion, in the first direction, of the bit line.
Clause 6. The semiconductor device of Clause 5, wherein: the plurality of bit lines are arranged spaced apart in the first direction and the second direction, the semiconductor device further includes a short bit line at one side of the plurality of bit lines in the first direction and having a length in the first direction shorter than that of the bit line,
and the short bit line protrudes in the direction away from the plurality of bit lines in the first direction with respect to a bit line adjacent in the second direction.
Clause 7. The semiconductor device of Clause 6, including a plurality of short bit lines spaced apart and arranged in the second direction, wherein the cell wiring layer includes a connection wiring connecting two short bit lines adjacent in the second direction.
Clause 8. The semiconductor device of Clause 7, further including a short bit line contact connecting the connection wiring and the short bit line, wherein the short bit line contact is connected to the end portion of the short bit line that is farther from the plurality of bit lines in the first direction.
Clause 9. The semiconductor device of Clause 1, including a plurality of active patterns spaced apart and arranged in the first direction, and a pair of word lines between two active patterns adjacent in the first direction, wherein in the third direction, the bit line insulating pattern overlaps the pair of word lines and does not overlap the active pattern.
Clause 10. The semiconductor device of Clause 1, including a plurality of active patterns arranged spaced apart in the first direction, wherein in the third direction, the bit line insulating pattern overlaps one of the plurality of active patterns.
Clause 11. A semiconductor device comprising: a plurality of bit lines extending in a first direction, a plurality of word lines on lower surfaces of the plurality of bit lines and extending in a second direction intersecting the first direction, a plurality of active patterns extending from the lower surfaces of the plurality of bit lines in a third direction substantially perpendicular to the first direction and the second direction, and overlapping the plurality of word lines in the first direction, a plurality of capacitors on lower surfaces of the plurality of active patterns, a cell wiring layer on upper surfaces of the plurality of bit lines, a plurality of bit line contacts connecting the cell wiring layer and the plurality of bit lines, and a plurality of bit line insulating patterns respectively between the plurality of bit lines spaced apart in the first direction, wherein: the plurality of bit lines include a plurality of first bit lines and a plurality of second bit lines adjacent in the second direction, each of the plurality of first bit lines and the plurality of second bit lines are arranged spaced apart in the first direction, and the plurality of first bit lines and the plurality of second bit lines are arranged in a staggered manner in the second direction.
Clause 12. The semiconductor device of Clause 11, wherein: the plurality of bit line contacts include a first bit line contact connected to the first bit line and a second bit line contact connected to the second bit line, the plurality of bit line insulating patterns include a first bit line insulating pattern between two first bit lines adjacent in the first direction and a second bit line insulating pattern between two second bit lines adjacent in the first direction, a portion of the first bit line connected to the first bit line contact overlaps the second bit line insulating pattern in the second direction, and a portion of the second bit line connected to the second bit line contact overlaps the first bit line insulating pattern in the second direction.
Clause 13. The semiconductor device of Clause 11, wherein the plurality of bit line contacts overlaps the plurality of capacitors in the third direction.
Clause 14. The semiconductor device of Clause 13, wherein: the plurality of first bit lines and the plurality of second bit lines are arranged to be alternately repeated along the second direction, and the plurality of bit line contacts include a plurality of first bit line contacts connected to one end portions, in the first direction, of the plurality of first bit lines, and a plurality of second bit line contacts connected to the other end portions, in the first direction, of the plurality of second bit lines.
Clause 15. The semiconductor device of Clause 13, wherein the plurality of bit line contacts are respectively connected to center portions, in the first direction, of the plurality of bit lines.
Clause 16. The semiconductor device of Clause 15, wherein: the plurality of first bit lines and the plurality of second bit lines are arranged alternately and repeatedly along the second direction, the semiconductor device further includes a plurality of short bit lines, the plurality of short bit lines include at least one short bit line, in the first direction, at one side of the plurality of bit lines and between the plurality of first bit lines that are spaced apart in the second direction, and at least one short bit line, in the first direction, at the other side of the plurality of bit lines and between the plurality of second bit lines that are spaced apart in the second direction, each of the plurality of short bit lines has a length along the first direction that is shorter than each of the plurality of bit lines, and the plurality of short bit lines protrude further, in a direction away from the plurality of bit lines in the first direction, than the plurality of first bit lines and the plurality of second bit lines.
Clause 17. The semiconductor device of Clause 16, wherein: the plurality of short bit lines are arranged spaced apart in the second direction, and the cell wiring layer includes a connection wiring connecting two short bit lines adjacent in the second direction.
Clause 18. The semiconductor device of Clause 17, wherein: the cell wiring layer includes a plurality of connection wirings, the semiconductor device includes a plurality of short bit line contacts connecting the plurality of connection wirings and the plurality of short bit lines, and each of the plurality of short bit line contacts is connected to an end portion of each of the plurality of short bit lines protruding in a direction away from the plurality of bit lines in the first direction.
Clause 19. A semiconductor device comprising: a plurality of bit lines extending in a first direction, a plurality of word lines on lower surfaces of the plurality of bit lines and extending in a second direction intersecting the first direction, a plurality of active patterns extending from the lower surfaces of the plurality of bit lines in a third direction substantially perpendicular to the first direction and the second direction, and overlapping the plurality of word lines in the first direction, a plurality of capacitors on the lower surfaces of the plurality of active patterns, a cell wiring layer on upper surfaces of the plurality of bit lines, a plurality of bit line contacts connecting the cell wiring layer and the plurality of bit lines, and a plurality of bit line insulating patterns respectively between the plurality of bit lines spaced apart in the first direction, wherein: the plurality of bit lines include a plurality of first bit lines and a plurality of second bit lines adjacent in the second direction, and each of the plurality of first bit lines and the plurality of second bit lines is arranged spaced apart in the first direction, the plurality of bit line insulating patterns include a plurality of first bit line insulating patterns alternately and repeatedly arranged with the plurality of first bit lines along the first direction, and a plurality of second bit line insulating patterns alternately and repeatedly arranged with the plurality of second bit lines along the first direction, the plurality of first bit lines overlap the plurality of second bit line insulating patterns in the second direction, the plurality of second bit lines overlap the plurality of first bit line insulating patterns in the second direction, and the plurality of bit line contacts overlap the plurality of capacitors in the third direction.
Clause 20. The semiconductor device of Clause 19, wherein: the plurality of bit line contacts includes a plurality of first bit line contacts connecting the plurality of first bit lines and the cell wiring layer, and a plurality of second bit line contacts connecting the plurality of second bit lines and the cell wiring layer, the plurality of second bit line insulating patterns overlaps, in the second direction, portions of the plurality of first bit lines to which the plurality of first bit line contacts are connected, and the plurality of first bit line insulating patterns overlaps, in the second direction, portions of the plurality of second bit lines to which the plurality of second bit line contacts are connected.

Although embodiments of the present invention have been described in detail above, the scope of rights of the present invention is not limited thereto, and various modifications and improved configurations by those skilled in the art utilizing the basic concept of the present invention as defined in the following claims also belong to the scope of rights of the present invention.

## Claims

1. A semiconductor device comprising:
a bit line (BL) extending in a first direction (DR1),
a word line (WL) on a lower surface of the bit line (BL) and extending in a second direction (DR2) intersecting the first direction (DR1),
an active pattern (AP) extending from the lower surface of the bit line (BL) in a third direction (DR3) intersecting the first direction (DR1) and the second direction (DR2), and overlapping the word line (WL) in the first direction (DR1),
a capacitor (DSP) on a lower surface of the active pattern (AP),
a cell wiring layer (262) on an upper surface of the bit line (BL),
a bit line contact (BLC) connecting the cell wiring layer (262) and the bit line (BL), and
a bit line insulating pattern (167) between two bit lines (BL) adjacent in the first direction (DR1) among a plurality of bit lines including the bit line (BL),
wherein the bit line insulating pattern overlaps (167), in the second direction (DR2), another bit line different from the two bit lines.

2. The semiconductor device of claim 1,
wherein the bit line contact (BLC) overlaps the capacitor (DSP) in the third direction (DR3).

3. The semiconductor device of claim 1 or 2,
wherein a portion of the bit line (BL) to which the bit line contact (BLC) is connected overlaps the bit line insulating pattern (167) in the second direction (DR2).

4. The semiconductor device of any preceding claim,
wherein:
the plurality of bit lines (BL) are spaced apart and arranged in the first direction (DR1) and the second direction (DR2), and a plurality of bit line contacts (BLC) including the bit line contact are respectively connected to the plurality of bit lines (BL),
the plurality of bit lines (BL) include a first bit line (BL1) and a second bit line (BL2) adjacent in the second direction (DR2),
the plurality of bit line contacts (BLC) include a first bit line contact (BLC1) connected to the first bit line (BL1) and a second bit line contact (BLC2) connected to the second bit line (BL2) ,
the first bit line contact (BLC1) is connected to one end portion of the first bit line (BL1) in the first direction (DR1), and
the second bit line contact (BLC2) is connected to another end portion of the second bit line (BL2) in the first direction (DR1).

5. The semiconductor device of any preceding claim,
wherein the bit line contact (BLC1, BLC2) is connected to a central portion, in the first direction (DR1), of the bit line (BL1, BL2).

6. The semiconductor device of any preceding claim,
wherein:
the plurality of bit lines (BL) are arranged spaced apart in the first direction (DR1) and the second direction (DR2),
the semiconductor device further includes a short bit line (SBL) at one side of the plurality of bit lines (BL) in the first direction (DR1) and having a length in the first direction (DR1) shorter than that of the bit line (BL), and
the short bit line (SBL) protrudes in the direction away from the plurality of bit lines (BL) in the first direction (DR1) with respect to a bit line adjacent in the second direction (DR2).

7. The semiconductor device of claim 6, including a plurality of short bit lines (SBL) spaced apart and arranged in the second direction (DR2),
wherein the cell wiring layer (262) includes a connection wiring (262C) connecting two short bit lines (SBL) adjacent in the second direction (DR2).

8. The semiconductor device of claim 7, further including a short bit line contact (SBLC) connecting the connection wiring (262C) and the short bit line (SBL),
wherein the short bit line contact (SBLC) is connected to the end portion of the short bit line (SBL) that is farther from the plurality of bit lines (BL) in the first direction (DR1).

9. The semiconductor device of claim 1, including a plurality of active patterns (AP) spaced apart and arranged in the first direction (DR1), and a pair of word lines (WL) between two active patterns (AP) adjacent in the first direction (DR1),
wherein in the third direction (DR3), the bit line insulating pattern (167) overlaps the pair of word lines (WL) and does not overlap the active pattern (AP).

10. The semiconductor device of claim 1, including a plurality of active patterns (AP) arranged spaced apart in the first direction (DR1),
wherein in the third direction (DR3), the bit line insulating pattern (167) overlaps one of the plurality of active patterns (AP).

11. The semiconductor device of claim 1, wherein:
the plurality of bit lines (BL) include a plurality of first bit lines (BL1) and a plurality of second bit lines (BL2) adjacent in the second direction (DR2),
each of the plurality of first bit lines (BL1) and the plurality of second bit lines (BL2) are arranged spaced apart in the first direction (DR1), and
the plurality of first bit lines (BL1) and the plurality of second bit lines (BL2) are arranged in a staggered manner in the second direction (DR2).

12. The semiconductor device of claim 11,
wherein:
a plurality of bit line contacts (BLC) including the bit line contact include a first bit line contact (BLC1) connected to the first bit line (BL1) and a second bit line contact (BLC2) connected to the second bit line (BL2),
the plurality of bit line insulating patterns (167) include a first bit line insulating pattern (167_1) between two first bit lines (BL1) adjacent in the first direction (DR1) and a second bit line insulating pattern (167_2) between two second bit lines (BL2) adjacent in the first direction (DR1),
a portion of the first bit line (BL1) connected to the first bit line contact (BLC1) overlaps the second bit line insulating pattern (167_2) in the second direction (DR1), and
a portion of the second bit line (BL2) connected to the second bit line contact (BLC2) overlaps the first bit line insulating pattern (167_1) in the second direction (DR2).

13. The semiconductor device of claim 12,
wherein the plurality of bit line contacts (BLC) overlaps the plurality of capacitors including the capacitor (DSP) in the third direction (DR3).

14. The semiconductor device of claim 12 or 13,
wherein:
the plurality of first bit lines (BL1) and the plurality of second bit lines (BL2) are arranged to be alternately repeated along the second direction (DR2), and
the plurality of bit line contacts (BLC) include a plurality of first bit line contacts (BLC1) connected to one end portions, in the first direction (DR1), of the plurality of first bit lines (BL1), and a plurality of second bit line contacts (BLC2) connected to the other end portions, in the first direction (DR1), of the plurality of second bit lines (BL2).

15. The semiconductor device of claim 12, 13 or 14,
wherein the plurality of bit line contacts (BLC) are respectively connected to center portions, in the first direction (DR1), of the plurality of bit lines (BL).
